# EUROPÄISCHE PATENTSCHRIFT

(11) **EP 0 510 440 B1**
(45) Veröffentlichungstag und Bekanntmachung des Hinweises auf die Patenterteilung: **13.01.1999**
(21) Anmeldenummer: 92106136.2
(22) Anmeldetag: 09.04.1992
(51) Int. Cl.: G03F 7/004

(54) **Positiv arbeitendes strahlungsempfindliches Gemisch und damit hergestelltes strahlungsempfindliches Aufzeichnungsmaterial**
Positive-working radiation-sensitive composition and radiation-sensitive recording material produced therewith
Composition photosensible positive et matériau d'enregistrement photosensible produit de celle-ci

(30) Priorität: 20.04.1991 DE 4112966
(43) Veröffentlichungstag der Anmeldung: 28.10.1992
(73) Patentinhaber: Clariant GmbH, 65929 Frankfurt am Main (DE)
(72) Erfinder: Lohaus, Gerhard, Dr., W-6233 Klekheim (DE); Spiess, Walter, Dr., W-6110 Dieburg (DE); Pawlowski, Georg, Dr., W-6200 Wiesbaden (DE)

(56) Entgegenhaltungen:
- EP-A- 0 329 610
- EP-A- 0 388 343
- EP-A- 0 417 556
- US-A- 4 376 818
- US-A- 4 425 424

## Beschreibung

Die Erfindung betrifft ein positiv arbeitendes strahlungsempfindliches Gemisch mit
a) einer Verbindung, die unter Einwirkung von aktinischer Strahlung eine starke Säure bildet,
b) einer Verbindung mit mindestens einer durch Säure spaltbaren C-O-C- oder C-O-Si-Bindung und
c) einem in Wasser unlöslichen, in wäßrig-alkalischen Lösungen löslichen oder zumindest quellbaren polymeren Bindemittel.

Die Erfindung betrifft weiterhin ein damit hergestelltes strahlungsempfindliches Aufzeichnungsmaterial, das zur Herstellung von Photoresists, elektronischen Bauteilen, Druckplatten oder zum Formteilätzen geeignet ist.

Zur Herstellung mikroelektronischer Schaltungen finden derzeit mehrere lithographische Techniken Anwendung. Mit der g-line-Lithographie (436 nm), die üblicherweise auf konventionelle Diazonaphthochinon/Novolak-Formulierungen angewendet wird, können Resistbilder mit einer Auflösung von bis zu 0,8 µm hergestellt werden. Noch feinere Strukturen (bis herab zu 0,5 µm) lassen sich mit Hilfe der i-Line-Lithographie (365 nm) auf einer Resistschicht abbilden. Neuere Modifikationen der i-line-Lithographie, wie beispielsweise die Phase-Shifting-Mask-Technologie erlauben eine weitere Verkleinerung der abzubildenden Strukturen bis herab zu etwa 0,35 µm oder kleiner. Eine noch höhere Auflösung läßt sich mit UV2-Photoresists erreichen. Dabei werden zwei Bestrahlungstechniken eingesetzt: die UV2-Breitbandbelichtung (240 bis 260 nm) oder die Belichtung mit KrF-Excimer-Lasern, die bei 248 nm emittieren.

Die stetige Verkleinerung der Strukturen, beispielsweise in der Chip-Herstellung bis in den Bereich von weniger als 1 µm, erfordert veränderte lithographische Techniken. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine Zusammenstellung der an das strahlungsempfindliche Gemisch gestellten Forderungen ist in dem Aufsatz von C.G. Willson "Organic Resist Materials - Theory and Chemistry" [Introduction to Microlithography, Theory, Materials, and Processing, Herausgeber L.F. Thompson, C.G. Willson, M.J. Bowden, ACS Symp. Ser., 219, 87 (1983), American Chemical Society, Washington] angegeben. Es bestand daher ein verstärkter Bedarf an strahlungsempfindlichen Gemischen, die in den neueren Technologien, wie der Mid- oder Deep-UV-Lithographie [Belichtung z. B. mit Excimer-Lasern bei Wellenlängen von 305 nm (XeF), 248 nm (KrF), 193 nm (ArF)], der Elektronen- oder der Röntgenstrahl-Lithographie, einsetzbar sind, vorzugsweise darüber hinaus in einem weiten Spektralbereich empfindlich sind und dementsprechend auch in der konventionellen UV-Lithographie verwendet werden können.

Gemische, die neben einem in Wasser unlöslichen, in wäßrig-alkalischen Lösungen löslichen oder zumindest quellbaren Bindemittel und einer unter Einwirkung von aktinischer Strahlung eine starke Säure bildenden Komponente als wesentlichen Bestandteil eine durch Säure spaltbare Verbindung, mit z. B. C-O-C- oder C-O-Si-Bindungen, aufweisen, sind prinzipiell bekannt, beispielsweise aus der DE-A 23 06 248 (= US-A 3 779 778).

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie HSbF₆, HAsF₆, oder HPF₆ [J.V. Crivello, Polym. Eng. Sci., 23 (1983) 953], verwendet. Daneben sind Halogenverbindungen, insbesondere Trichlormethyltriazin-Derivate, Trichlormethyloxadiazol-Derivate und o-Chinondiazidsulfochloride empfohlen worden.

Diese Verbindungen werden in negativ oder positiv arbeitenden strahlungsempfindlichen Gemischen verwendet. Die Verwendung solcher photolytischer Säurebildner bringt aber Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, weshalb nur wenige Lösemittel zur Herstellung einer Beschichtungslösung geeignet sind. Darüber hinaus werden bei Verwendung der Oniumsalze z.T. unerwünschte Fremdatome eingeführt, die insbesondere in der Mikrolithographie zu Prozeßstörungen führen können. Ferner bilden die Oniumsalze bei der Photolyse sehr stark korrodierend wirkende Brönstedt-Säuren. Diese Säuren greifen empfindliche Substrate an, so daß der Einsatz solcher Gemische zu unbefriedigenden Ergebnissen führt. Wie bereits früher erwähnt, bilden auch die Halogenverbindungen sowie die Chinondiazidsulfonsäurechloride stark korrosiv wirkende Halogenwasserstoffsäuren. Ferner besitzen derartige Verbindungen auf bestimmten Substraten nur eine begrenzte Haltbarkeit, die dadurch verbessert wurde, daß zwischen Substrat und strahlungsempfindlicher, Verbindungen des Typs (a) enthaltender Schicht eine Zwischenschicht eingefügt wurde, was allerdings zu einer unerwünschten Zunahme von Defekten und zu einer verminderten Reproduzierbarkeit führte (DE-A 36 21 376 = US-A 4 840 867).

In neueren Arbeiten von F.M. Houlihan et al., SPIE 920, 67 (1988) wurden anhand positiv arbeitender Systeme gezeigt, daß neben den oben genannten Säurebildnern auch Nitrobenzyltosylate, die bei Belichtung Sulfonsäuren mit geringer Wanderungstendenz bilden, in bestimmten säurelabilen Resistformulierungen verwendbar sind. Es kann aus diesen Ergebnissen abgeleitet werden, daß solche Verbindungen auch für photohärtbare Systeme verwendet werden können. Die dabei erzielten Empfindlichkeiten, insbesondere gegenüber UV-Strahlung von 350 bis 450 nm und die thermische Stabilität der Photoresists erwiesen sich jedoch als unzureichend.

Bereits bekannt sind auch Resistformulierungen mit Naphthochinon-2-diazid-4-sulfonsäureestern, Oximsulfonaten, 1,2-Disulfonen, Bis-sulfonyl-diazomethan (DE-A 39 30 086) und Sulfonyl-carbonyl-diazomethan (DE-A 39 30 087). All diese Verbindungen bilden unter der Einwirkung aktinischer Strahlung nicht korrodierend wirkende Sulfonsäuren. Sie sind jedoch häufig nicht ausreichend thermostabil. Die photochemische Reaktion verläuft zudem mit einer unbefriedigenden Quantenausbeute. Die Resistformulierungen absorbieren Strahlung der Wellenlänge 248 nm in beträchtlichem Maße. Die Empfindlichkeit gegenüber Strahlung dieser Wellenlänge liegt im Bereich von 50 bis 100 mJ/cm². Praxisgerechte Strukturen einer Größenordnung von 0,5 µm und weniger lassen sich mit solchen Resists nicht abbilden.

Es ist ferner bekannt, mit Methan-, Ethan-, Propan-, Butan-, Benzol-, Toluol- oder Naphthalinsulfonsäure vollständig verestertes 1,2,3-Trihydroxy-benzol als photoaktiven Säurebildner in positiv arbeitenden Photoresistsystemen zu verwenden [T. Ueno et al., Chemical Amplification Positive Resist Systems Using Novel Sulfonates as Acid Generators, in "Polymers for Microelectronics - Science and Technology", Hrsg. Y. Tabata et al., Kodansha-Weinheim-New York, 1989, S. 66-67]. Diese Resistsysteme finden jedoch in der Praxis keine Verwendung, da ihre thermische Stabilität und Plasmaätzresistenz unzureichend ist und nach der Entwicklung Resistreste in den Gräben und nicht akzeptable Resistprofile zu beobachten sind. Die Empfindlichkeit dieser Resistsysteme ist auf den UV2-Bereich begrenzt.

Trotz der bisher geleisteten intensiven Forschungstätigkeit auf diesem Gebiet ist derzeit kein strahlungsempfindliches Gemisch bekannt, mit dem sich ein positiv arbeitendes strahlungsempfindliches Aufzeichnungsmaterial herstellen läßt, das eine hohe Empfindlichkeit sowohl im deep-UV- [DUV (200 bis 300 nm)] als auch im mid-UV- [MUV (300 bis 350 nm)] und near-UV-Bereich [NUV (350 bis 450 nm)] sowie eine hohe Auflösung besitzt, bereits bei kurzzeitiger Bestrahlung eine ausreichende Menge einer nicht korrodierend wirkenden Säure freisetzt, die stark genug ist, um Verbindungen des Typs b) zu spalten und das zudem noch wäßrig-alkalisch entwickelbar ist.

Aufgabe der Erfindung war es daher, ein strahlungsempfindliches Gemisch auf Basis von säurebildenden in Kombination mit säurespaltbaren Verbindungen vorzuschlagen, wobei die photolytisch eine Säure bildende Verbindung (a) möglichst stabil auf allen bekannten Substraten sein sollte und als Photoprodukt eine nicht korrosiv wirkende Säure liefert.

Die Aufgabe wird gelöst durch ein positiv arbeitendes strahlungsempfindliches Gemisch mit
a) einer Verbindung, die unter Einwirkung von aktinischer Strahlung eine starke Säure bildet,
b) einer Verbindung mit mindestens einer durch Säure spaltbaren C-O-C- oder C-O-Si-Bindung und
c) einem in Wasser unlöslichen, in wäßrig-alkalischen Lösungen löslichen oder zumindest quellbaren polymeren Bindemittel,
das dadurch gekennzeichnet ist, daß die Verbindung (a) ein 1-Sulfonyloxy-2-pyridon der allgemeinen Formel I 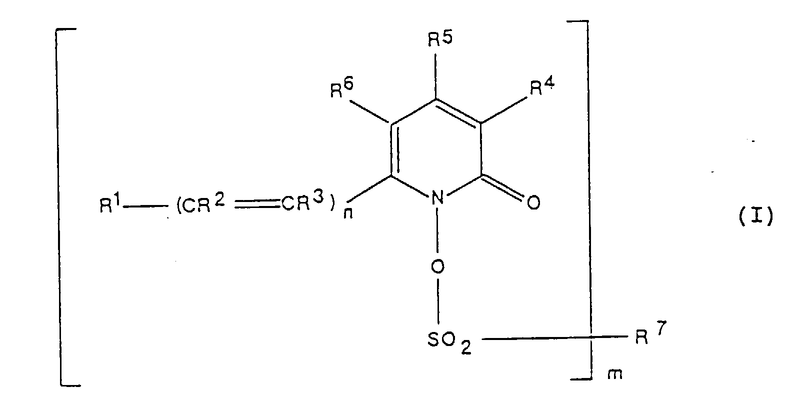 ist, worin
- R¹: ein Wasserstoffatom, einen Alkyl-, Cycloalkyl-, Aryl-, Aralkenyl-, Heteroaryl- oder Heteroaralkenylrest,
- R²: Wasserstoff, Chlor, Brom, einen Alkyl-, Cycloalkyl-, Aryl- oder Heteroarylrest oder
- R¹ und R²: gemeinsam einen fünf- bis achtgliedrigen Ring ausbilden,
- R³: Wasserstoff oder einen Alkylrest,
- R⁴: Wasserstoff, Halogen, Nitro, Acylamino, Cyan, Thiocyanato, einen Alkyl-, Alkenyl-, Alkinyl-, Aryl-, Aralkyl-, Alkylthio-, Arylthio- oder Cycloalkylthiorest,
- R⁵: Wasserstoff, einen Alkyl- oder Arylrest oder
- R⁴ und R⁵: zusammen einen fünf- bis achtgliedrigen Ring ausbilden,
- R⁶: Wasserstoff, Halogen, Nitro, Acylamino, Cyan, Thiocyanato, einen Alkyl-, Alkenyl-, Alkoxyalkyl-, Aryl-, Aralkyl-, Alkylthio-, Cycloalkylthio- oder Arylthiorest,
- R⁷: einen Alkyl-, Cycloalkyl, per- oder hochfluorierten Alkylrest oder einen Aryl-, Arylalkyl- oder Heteroarylrest oder einen Alkylen- oder Arylenrest,
- n: eine ganze Zahl von 0 bis 3 und
- m: die Zahl 1 oder 2
bedeuten.

Die Verbindungen a) bilden unter Einwirkung von aktinischer Strahlung reaktive Zwischenstufen, die zur Einleitung spezieller chemischer Reaktionen, beispielsweise radikalischer Polymerisationen, befähigt sind. Sie bilden bei ihrer Bestrahlung jedoch insbesondere organische Säuren, die Reaktionen, wie kationische Polymerisationen, Vernetzungen oder Spaltungen säurelabiler Verbindungen katalysieren oder mit Basen reagieren können, was sich z. B. in einem Farbumschlag bei Indikatorfarbstoffen äußern kann.

Von den Verbindungen der allgemeinen Formel I sind solche bevorzugt, in denen
- R¹: ein Alkyl- oder Cycloalkylrest oder ein Arylrest der allgemeinen Formel II 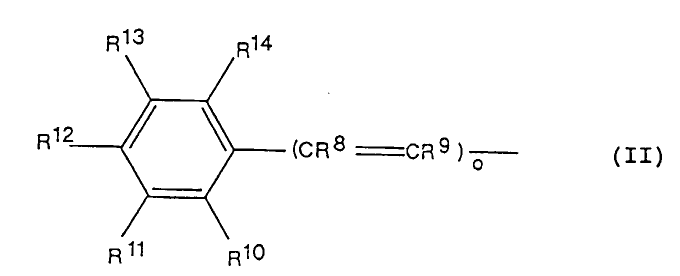 ist, worin
- R⁸ und R⁹: gleich oder verschieden sind und Wasserstoff, eine niedere Alkyl- oder Arylgruppe darstellen,
- R¹⁰ bis R¹⁴: gleich oder verschieden sind und Wasserstoff, einen Alkyl-, Alkenyl-, Alkoxy-, Alkylthio-, Alkansulfonylrest mit jeweils bis zu 6 Kohlenstoffatomen, einen Cycloalkyloxy-, Cycloalkylthio-, Cycloalkansulfonylrest mit bis zu 8 Kohlenstoffatomen, gegebenenfalls am aromatischen Ring substituierten Phenyl-, Styryl-, Phenoxy-, Phenylthio-, Benzolsulfonyl-, Phenylalkoxy-, Phenylalkylthio-, Phenylalkansulfonylrest mit bis zu 3 Kohlenstoffatomen in der Alkylkette, Hydroxy, Halogen, Trifluormethyl, Nitro, Cyan, Alkoxycarbonyl, Carbamoyl, das gegebenenfalls am Stickstoff durch einen oder zwei Alkylrest(e), die gegebenenfalls zu einem 5- bis 7-gliedrigen Ring verbunden sind, substituiert ist, Sulfamoyl, das gegebenenfalls am Stickstoff durch ein oder zwei Alkylrest(e), die gegebenenfalls zu einem 5- bis 7-gliedrigen Ring verbunden sind, substituiert ist, Alkansulfonyloxy, Arylsulfonyloxy, Acylamino, Alkylamino oder Arylamino bedeuten,
oder zwei der Substituenten R¹⁰ bis R¹⁴, die einander benachbart sind, einen oder zwei weitere ankondensierte Ring(e) bilden, und
- o: für die Zahl 0 oder 1 steht.

Daneben sind auch solche Verbindungen der allgemeinen Formel I bevorzugt, in denen R¹ ein 5- oder 6-gliedriger Heterocyclus mit bis zu drei Heteroatomen der allgemeinen Formel III 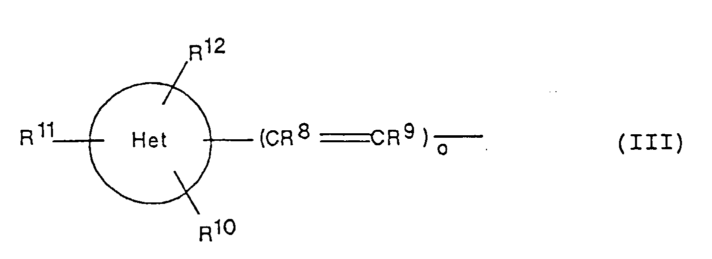 ist. Bevorzugte Verbindungen der allgemeinen Formel I sind schließlich auch solche, in denen
- R¹: ein Ferrocenylrest und
- R²: Wasserstoff, Chlor, Brom, Alkyl-, Cycloalkyl oder ein Rest der allgemeinen Formeln II oder III ist oder
- R¹ und R²: gemeinsam einen fünf- bis achtgliedrigen Ring ausbilden,
- R³: Wasserstoff oder ein Alkylrest,
- R⁴: Wasserstoff, Halogen, Nitro, Acylamino, Cyan, Thiocyanato, ein Alkyl-, Aryl-, Alkylthio-, Arylthio- oder Cycloalkylthiorest,
- R⁵: Wasserstoff, ein Alkyl- oder Arylrest ist oder
- R⁴ und R⁵: gemeinsam einen fünf- bis achtgliedrigen Ring ausbilden,
- R⁶: Wasserstoff, Halogen, Nitro, Acylamino, Cyan, Thiocyanato, ein Alkyl-, Aryl-, Alkylthio-, Arylthio- oder Cycloalkylthiorest,
- R⁷: ein Alkyl-, Cycloalkyl-, per- oder hochfluorierten Alkylrest oder ein Aryl-, Arylalkyl-, Aryl- oder Heteroarylrest oder ein Alkylen- oder Arylenrest ist und
- m: für die Zahl 1 oder 2 und
- n: für eine ganze Zahl von 0 bis 3 steht.

Besonders bevorzugt sind solche Verbindungen der allgemeinen Formel I, worin R⁷ ein Alkylrest mit 1 bis 4 Kohlenstoffatomen, ein hoch- oder perfluorierter Alkylrest mit 1 bis 4 Kohlenstoffatomen oder ein Arylrest der allgemeinen Formel IV 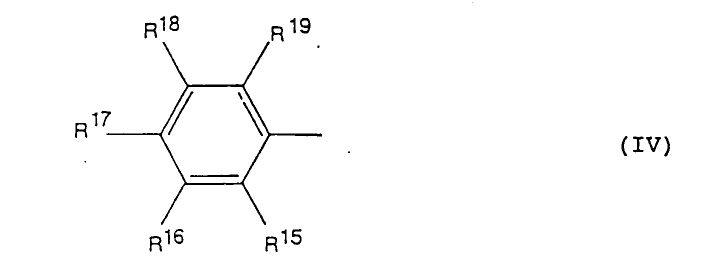 ist, worin R¹⁵ bis R¹⁹ gleich oder verschieden sind und Wasserstoff- oder Halogenatome, die vorzugsweise Fluor, Chlor oder Brom sind, Alkylreste mit bis zu 6 Kohlenstoffatomen, die unsubstituiert oder durch Halogenatome, vorzugsweise Chlor oder Brom, Aryl- oder Aryloxyreste, substituiert sind und in denen einzelne Methylengruppen durch Sauerstoff- oder Schwefelatome ersetzt sein können und wobei jeweils zwei dieser Reste unter Ausbildung eines 5- oder 6-gliedrigen Rings verknüpft sein können, Cycloalkylreste mit bis zu 8 Kohlenstoffatomen, Alkenylreste mit bis zu 6 Kohlenstoffatomen, Aryl- oder Aryloxyreste mit bis zu 10 Kohlenstoffatomen bedeuten und die Gesamtzahl der Kohlenstoffatome der Reste R¹⁵ bis R¹⁹ maximal 12 beträgt.

Bevorzugt sind ebenfalls Verbindungen der allgemeinen Formel I, in denen R⁷ ein Naphthyl- oder Heteroarylrest mit bis zu 10 Kohlenstoffatomen, ein Alkylenrest mit bis zu 6 Kohlenstoffatomen oder ein Arylen- oder Heteroarylenrest mit bis zu 14 Kohlenstoffatomen ist.

Ganz besonders bevorzugt sind solche Verbindungen der allgemeinen Formel I, worin
- R², R³, R⁴ und R⁶: ein Wasserstoffatom,
- R⁵: eine Methylgruppe,
- R⁷: einen Methyl-, Ethyl-, Trifluormethyl-, 1,1,2,3,3,3-Hexafluorpropyl-, Phenyl-, Tolyl-, 4-Fluorphenyl-, 4-Chlorphenyl-, 4-Bromphenyl oder 4-Nitrophenylrest,
- m: die Zahl 1 und
- n: die Zahl 0 oder 1
bedeuten.

Im einzelnen kann unter den besonders bevorzugten Verbindungen der Rest R⁷ z.B. die folgende Bedeutung haben: Methyl, Ethyl, Propyl, Isopropyl, Butyl, Hexyl, Octyl, Decyl, Dodecyl, Hexadecyl, Octadecyl, 10-Camphyl, Chlormethyl, 2-Chlorethyl, 3-Chlorpropyl, Dichlormethyl, Trichlormethyl, Difluormethyl, Trifluormethyl, 2,2,2-Trifluorethyl, 3,3,3,2,1,1-Hexafluorpropyl, Perfluorhexyl, Trimethylsilylmethyl, Methansulfonylmethyl, Phenyl, Benzyl, 4-Acetylphenyl, 4-Acetylaminophenyl, 2-, 3-oder 4-Bromphenyl, 2-, 3- oder 4-Chlorphenyl, 2-, 3-oder 4-Fluorphenyl, 4-Jodphenyl, 2-Cyanphenyl, 4-Cyanphenyl, 2-, 3- oder 4-Methylphenyl, 4-Ethylyphenyl, 4-Propylphenyl, 4-Isopropylphenyl, 4-Isobutylphenyl, 4-tert.-Butylphenyl, 4-tert.-Amylphenyl, 4-Hexylphenyl, 4-Methoxyphenyl, 4-Butoxyphenyl, 4-Hexadecyloxyphenyl, 2-, 3- oder 4-Trifluormethylphenyl, 2- oder 4-Trifluormethoxyphenyl, 2-, 3- oder 4-Nitrophenyl, 3-oder 4-Carboxyphenyl, 2-Methoxycarbonylphenyl, 4-Tetrafluorethoxyphenyl, β-Styryl, 4-Acetylamino-3-chlorphenyl, 4-Acetylamino-3-fluorphenyl, 3,5-Bistrifluormethylphenyl, 2,5-Bis-(2,2,2-trifluorethoxy)phenyl, 2,5-Dimethylphenyl, 2,4-, 2,5- oder 3,4-Dimethoxyphenyl, 2,4-Diisopropylphenyl, 5-Brom-2-methoxyphenyl, 2- oder 3-Chlor-4-fluorphenyl, 3-Chlor-2-methylphenyl, 3-Chlor-4-methoxyphenyl, 2-Chlor-6-methylphenyl, 2-Chlor-4-trifluormethylphenyl, 5-Chlor-2-methoxyphenyl, 5-Fluor-2-methylphenyl, 2,5- oder 3,4-Dibromphenyl, 2,3-, 2,4-oder 2,5-, 2,6-, 3,4- oder 3,5-Dichlorphenyl, 2-(2,4-Dichlorphenoxy)phenyl, 4-(2-Chlor-6-nitrophenoxy)phenyl, 4-(3-Chlor-2-cyanphenoxy)phenyl, 2,4- oder 2,5-Difluorphenyl, 3-Carboxy-4-chlorphenyl, 4-Chlor-3-nitrophenyl, 2-Methyl-5-nitrophenyl, 4-Chlor-3- oder 2-Chlor-5-trifluormethylphenyl, 4-(2,2-Dichlorcyclopropyl)phenyl, 2,4-Dinitrophenyl, 4-Dimethylamino-3-nitrophenyl, 2-Nitro-4-trifluormethylphenyl, 2,4,6-Trimethylphenyl, 2,4,6-Triisopropylphenyl, 2,3,4-, 2,4,5- oder 2,4,6-Trichlorphenyl, 4-Chlor-2,5-dimethylphenyl, 2,4-Dichlor-5-methylphenyl, 3,5-Dichlor-2-hydroxyphenyl, 3,5-Dichlor-4-(4-nitrophenoxy)phenyl, 4-(2-Chlor-4-nitrophenoxy)-3,5-Dichlorphenyl, 4-Brom-2,5-difluorphenyl, 2,4-Dimethyl-3-nitrophenyl, 3,5-Dinitro-4-methylphenyl, 2,3,5,6-Tetramethylphenyl, 4-Methoxy-2,3,6-trimethylphenyl, 2,5-Dibrom-3,6-difluorphenyl, 2,3,4,5,6-Pentafluorphenyl, 1-oder 2-Naphthyl, 5-Diazo-6-oxo-5,6-dihydro-l-naphthyl, 6-Diazo-5-oxo-5,6-dihydro-l-naphthyl, 5-Diazo-6-oxo-5,6-dihydro-8-naphthyl, 5-Diazo-3-methoxy-6-oxo-5,6-dihydro-8-naphthyl, 5-Dimethylamino-l-naphthyl, 1-Anthracenyl, 2-Anthrachinonyl, 8-Chinolinyl, 2-Thienyl, 5-Chlor-2-thienyl, 4-Brom-2,5-dichlor-3-thienyl, 4,5-Dibrom-2-thienyl, 2,3-Dichlor-5-thienyl, 2-Brom-3-Chlor-5-thienyl, 3-Brom-2-chlor-5-thienyl, 3-Brom-5-chlor-2-thienyl, 2,5-Dichlor-3-thienyl, 2-(2-Pyridyl)-5-thienyl, 5-Chlor-1,3-dimethyl-4-pyrazolyl, 3,5-Dimethyl-4-isoxazolyl, 2,4-Dimethyl-5-thiazolyl, 2-Acetylamino-4-methyl-5-thiazolyl oder

1,4-Butylen, 2-Oxo-1,3-propylen, 1,2- oder 1,3-Phenylen, 3-Methyl-1,2-phenylen, 2,4,6-Trimethyl-1,3-phenylen, 4,4'-Biphenylen, 4,4'-Methylendiphenylen, 4,4'-Oxybiphenylen, 1,5-Naphthylen, 2-Chlor-3,5-thienylen, 2-(1-Methyl-5-trifluormethylpyrazol-3-yl)-3,5-thienylen.

Im einzelnen kann unter den besonders bevorzugten Verbindungen der Rest R¹ z.B. die folgende Bedeutung haben:

Methyl, Chlormethyl, Brommethyl, Ethyl, Propyl, Isopropyl, Butyl, Isobutyl, Hexyl, Cyclohexyl, Octyl, Phenyl, 4-Acetylaminophenyl , 4-Acetoxyphenyl , 3- oder 4-Benzyloxyphenyl, 3-Benzyloxy-4-methoxyphenyl, 4-Benzyloxy-3-methoxyphenyl, 4-Biphenyl, 3,5-Bis(trifluormethyl)phenyl, 2-, 3- oder 4-Fluorphenyl, 2-, 3-oder 4-Chlorphenyl, 2-,3- oder 4-Bromphenyl, 4-Jodphenyl, 2-, 3- oder 4-Cyanphenyl, 2-, 3- oder 4-Methylphenyl, 2-, 3- oder 4-Ethylphenyl, 2-, 3- oder 4-Propylphenyl, 2-, 3- oder 4-Isopropylphenyl, 2-, 3- oder 4-Butylphenyl, 2-, 3- oder 4-Isobutylphenyl, 2-, 3- oder 4-sec.-Butylphenyl, 2-, 3- oder 4-tert.-Butylphenyl, 2-, 3- oder 4-Pentylphenyl, 2-, 3- oder 4-Hexylphenyl, 2-, 3- oder 4-Cyclohexylphenyl, 2-, 3- oder 4-Nonylphenyl oder 2-, 3- oder 4-Dodecylphenyl, 2-, 3- oder 4-Methoxyphenyl, 2-, 3- oder 4-Ethoxyphenyl, 2-, 3- oder 4-Isopropoxyphenyl, 2-, 3- oder 4-Butoxyphenyl, 2-, 3- oder 4-Pentoxyphenyl, 2-, 3- oder 4-Octyloxyphenyl, oder 2-, 3- oder 4-Decyloxyphenyl, 2,3-, 2,4-, 2,6-, 3,4- oder 3,5- Difluorphenyl, 2,3-, 2,4-, 2,6-, 3,4- oder 3,5-Dichlorphenyl, 2,3-, 2,4-, 2,6-, 3,4- oder 3,5-Dibromphenyl, 3-(3,4-Dichlorphenoxy)phenyl, 3-(3,5-Dichlorphenoxy)phenyl, 3-Brom-4-fluorphenyl, 5-Brom-2,4-dimethoxyphenyl, 2-Chlor-6-fluorphenyl, 2-Chlor-5-, 2-Chlor-6-, 4-Chlor-3- oder 5-Chlor-2-nitrophenyl, 3-(4-Chlorphenoxy)phenyl, 3,4-Bisbenzyloxy-phenyl, 2,3-, 2,4-, 2,5-, 3,4- oder 3,5-Dimethoxy-phenyl, 2,3-, 2,4-, 2,5-, 3,4- oder 3,5-Diethoxy-phenyl, 2,3-, 2,4-, 2,5-, 3,4- oder 3,5-Dibutoxy-phenyl oder 2,3-, 2,4-, 2,5-, 3,4- oder 3,5-Dihexyloxy-phenyl, 2,4-Dimethoxy-3-methylphenyl, 2-Ethoxy-5-methoxy-phenyl, 3-Chlor-4-methyl-phenyl, 2,4- oder 2,5-Dimethyl-phenyl, 2-, 3- oder 4-Methoxyethyl-phenyl, 2-, 3- oder 4-Ethoxyethyl-phenyl, 2-, 3- oder 4-Butoxyethyl-phenyl, 2,6-Dinitro-phenyl, 2,4,6-Trimethylphenyl, 3,4,5-Trimethoxy-phenyl, 3,4,5-Triethoxy-phenyl, 2,3- oder 3,4-Methylendioxyphenyl, 2- oder 3-Thienyl, 2-Fluorenyl, 9-Anthryl, 1-Pyrenyl, 9-Phenanthryl, 5-Brom-2-thienyl, 3-Methyl-2-thienyl, 5-Methyl-2-thienyl, 5-Nitrofuryl, 10-Chlor-9-anthryl oder Ferrocenyl.

Diese Reste sind besonders deshalb bevorzugt, weil die ihnen zugrundeliegenden Ausgangsverbindungen kommerziell erhältlich sind. Weitere Verbindungen sind aber auf einfache Weise nach dem Fachmann geläufigen Methoden herstellbar.

Die oben aufgeführten Verbindungen haben Absorptionsmaxima im Bereich zwischen 200 bis 550 nm und sind daher für eine Bestrahlung mit energiereicher UV-Strahlung im Bereich der UV2- (220 bis 280 nm), UV3- (300 bis 350 nm) oder UV4- (350 bis 450 nm) Strahlung sowie mit energiereichem sichtbaren Licht (450 bis 550 nm) sehr gut geeignet. Sie zeigen auch bei Bestrahlung mit Strahlung einer Wellenlänge < 220 nm hohe Aktivitäten; sind aber wegen ihrer hohen Absorption in diesem Bereich bevorzugt für sogenannte "Toplayer Imaging" Verfahren anwendbar.

1-Benzolsulfonyloxy- und 1-(Toluol-4-sulfonyloxy)-2-pyridon sowie Verfahren zu deren Herstellung sind bekannt (E.C. Taylor et al., J. Org. Chem., 35, 1672, 1970). Die Strahlungsempfindlichkeit dieser Verbindungen wurde jedoch nicht erkannt. Neue l-Sulfonyloxy-2-pyridone sind in der gleichzeitig eingereichten deutschen Patentanmeldung P 41 12 967.9 beschrieben.

Die Verwendung von l-Sulfonyloxy-2-pyridonen als Photooxidantien in strahlungsempfindlichen Gemischen, die einen Leukofarbstoff enthalten, ist aus der US-A 4 425 424 bekannt. In derartigen Gemischen bewirkt das Photooxidans bei der Bestrahlung beispielsweise eine Oxidation des Leukofarbstoffs, der dabei eine intensive Farbänderung eingeht und einen visuellen Kontrast zwischen belichteten und unbelichteten Bereichen hervorruft. Solche Farbumschläge sind in der Technik beispielsweise bei der Herstellung von Druckformen erwünscht, um nach der Belichtung bereits vor der Entwicklung das Kopierergebnis beurteilen zu können.

Das erfindungsgemäße strahlungsempfindliche Gemisch zeichnet sich durch eine hohe Empfindlichkeit über einen weiten Spektralbereich aus. Es zeigt eine hohe thermische Stabilität und schafft die Möglichkeit, auch feinste Strukturen einer Vorlage detailgenau wiederzugeben. Die bei der Bestrahlung gebildete Säure wirkt nicht korrodierend, so daß das Gemisch auch auf empfindlichen Substratmaterialien Verwendung finden kann.

Überraschenderweise bilden sich bei der Bestrahlung der erfindungsgemäßen Gemische Sulfonsäuren mit einer hohen Quantenausbeute. Infolge ihres hohen Molekukargewichts zeigen die Sulfonsäuren eine sehr geringe Diffusionsneigung bzw. Beweglichkeit in der strahlungsempfindlichen Schicht. Die hohe Effizienz der Säurebildung bedeutet, daß die erfindungsgemäßen Gemische eine wesentlich gesteigerte Empfindlichkeit aufweisen. Die erfindungsgemäßen, positiv arbeitenden, strahlungsempfindlichen Gemische zeigen zudem nicht nur eine hohe thermische und Plasmaätzbeständigkeit sondern auch hervorragende lithographische Eigenschaften, die eine Auflösung im Halbmikrometer- und teilweise auch im SubHalbmikrometer-Bereich erlauben. Man erhält nach dem bildmäßigen Bestrahlen und anschließendem Entwickeln ein detailgetreues Abbild der Maske. Die Resistfelder weisen steile Flanken auf. In den bestrahlten Bereichen wird die Resistschicht vollständig abgelöst, d. h. es bleiben keinerlei Reste oder Rückstände der Schicht auf dem Substrat. Die bei der Photolyse gebildeten Sulfonsäuren führen zu einer effizienten Spaltung der Resist-Komponente b), was die Herstellung von hochempfindlichen, positiv arbeitenden Gemischen erlaubt.

Weiterhin war es überraschend, daß die 1-Sulfonyloxy-2-pyridone der allgemeinen Formel I auch durch energiereiche, kurzwellige Strahlung aktivierbar sind und damit beispielsweise die Herstellung eines hochempfindlichen Photoresists für energiereiche UV2-Strahlung (248 nm) möglich ist. Insbesondere war es aber unerwartet, daß sogar noch im Bereich der klassischen optischen Lithographie (436 nm) eine ausreichende spektrale Empfindlichkeit vorhanden ist, die zu einer Spaltung des Moleküls in eine Sulfonsäure führt.

In dem erfindungsgemäßen Gemisch sollen die 1-Sulfonyloxy-2-pyridone eine höhere molare Absorption für Strahlung der Wellenlänge von etwa 220 bis 500 nm aufweisen als die übrigen Bestandteile des Gemisches.

Mit den erfindungsgemäßen Gemischen hergestellte Aufzeichnungsmaterialien zeigen eine höchsten Ansprüchen genügende Bilddifferenzierung und eine Verbesserung des Kontrasts und des Auflösungsvermögens. Die erfindungsgemäßen Gemische erlauben beispielsweise die Herstellung eines hochempfindlichen positiv arbeitenden Photoresists für energiereiche UV2-Strahlung (z. B. 248 nm).

Da das erfindungsgemäße Gemisch über einen weiten Spektralbereich empfindlich ist, ist zum bildmäßigen Bestrahlen aktinische Strahlung allgemein geeignet. Als aktinische Strahlung soll in diesem Zusammenhang jede Strahlung verstanden werden, deren Energie mindestens der des kurzwelligen sichtbaren Lichts (< 550 nm) entspricht. Geeignet ist dabei insbesondere UV-Strahlung im Bereich von 150 bis 550 nm, bevorzugt von 200 bis 450 nm, besonders bevorzugt von 240 bis 440 nm, aber auch Elektronen- oder Röntgenstrahlung.

Darüber hinaus lassen sich die mehrfunktionellen Sulfonsäureester auch mit Onium-Salzen, Halogenverbindungen, insbesondere Trichlormethyltriazinderivaten oder Trichlormethyloxadiazolderivaten, 1,2-Disulfonen, o-Chinondiazidsulfonylchloriden oder Organometall-Organohalogen-Kombinationen kombinieren. Es kommen aber auch Mischungen mit Bis(sulfonyl)diazomethanen und Sulfonyl-carbonyldiazomethanen in Frage. In solchen Gemischen können jedoch die eingangs erwähnten Nachteile wieder auftreten.

Der Anteil an säurebildenden Verbindungen a) im erfindungsgemäßen Gemisch liegt im allgemeinen bei 0,5 bis 25 Gew.-%, bevorzugt bei 1 bis 15 Gew.-%, bezogen auf das Gesamtgewicht der Feststoffe im Gemisch.

Als säurespaltbare Verbindungen b) in dem erfindungsgemäßen, strahlungsempfindlichen Gemisch haben sich vor allem folgende Verbindungsklassen bewährt:
1) solche mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können (DE-A 26 10 842 und 29 28 636),
2) oligomere oder polymere Verbindungen mit wiederkehrenden Acetal- und/oder Ketalgruppen in der Hauptkette (DE-A 23 06 248 und 27 18 254),
3) Verbindungen mit mindestens einer Enolether- oder N-Acyliminocarbonatgruppe (EP-A 0 006 626 und 0 006 627),
4) cyclische Acetale oder Ketale von β-Ketoestern oder -amiden (EP-A 0 202 196),
5) Verbindungen mit Silylethergruppen (DE-A 35 44 165 und 36 01 264),
6) Verbindungen mit Silylenolethergruppen (DE-A 37 30 785 und 37 30 783),
7) Monoacetale bzw. Monoketale von Aldehyden bzw. Ketonen, deren Löslichkeit im Entwickler zwischen 0,1 und 100 g/l beträgt (DE-A 37 30 787),
8) Ether auf der Basis tertiärer Alkohole (US-A 4 603 101),
9) Carbonsäureester und Carbonate, deren Alkoholkomponente ein tertiärer Alkohol, ein Allylalkohol oder ein Benzylalkohol ist (US-A 4 491 628 und J. M. Fréchet et al., J. Imaging Sci. 30, 59-64, 1986), und
10) N,O-Acetale (nicht vorveröffentlichte deutsche Patentanmeldung P 41 12 968.7).

Die Verbindung b) bzw. die Kombination von Verbindungen b) hat einen Anteil von 1 bis 60 Gew.-%, bevorzugt 5 bis 50 Gew.-%, am Gesamtgewicht der Feststoffe des strahlungsempfindlichen Gemisches.

Das erfindungsgemäße strahlungsempfindliche Gemisch enthält ferner mindestens ein polymeres, in Wasser unlösliches, in wäßrig-alkalischen Lösungen dagegen lösliches, zumindest quellbares Bindemittel c). Das Bindemittel zeichnet sich im besonderen dadurch aus, daß es mit den übrigen Bestandteilen des erfindungsgemäßen strahlungsempfindlichen Gemisches gut verträglich ist und insbesondere im Wellenlängenbereich von 190 bis 300 nm eine möglichst geringe Eigenabsorption, d.h. eine hohe Transparenz, aufweist.

Für die klassischen Anwendungen, d. h. mit Lichtquellen im nahen UV-Bereich, sind dazu insbesondere Bindemittel auf der Basis von Novolak-Kondensationsharzen, die in der Regel in Kombination mit Naphthochinondiaziden als photoaktive Komponenten eingesetzt worden sind, geeignet. Solche Phenol-Formaldehyd-Kondensate sind mehrfach beschrieben worden und können als phenolische Komponente Phenol, die drei stellungsisomeren Kresole oder andere Alkylphenole, z. B. Xylenole, als Komponenten enthalten. Neben Formaldehyd können auch andere Aldehyde zur Herstellung des Polymeren herangezogen werden. Allerdings lassen sich auch die nachstehend beschriebenen, Hydroxylgruppen enthaltenden Polymeren für Bestrahlungen mit nahem UV-Licht verwenden, wobei diese den oben bezeichneten Novolak-Polymeren in einem Anteil von bis zu 50%, bevorzugt bis zu 20%, zugemischt sein können.

Für Anwendungen im UV2 Bereich sind jedoch andere polymere Materialien erforderlich. Hierunter fallen insbesondere nicht diejenigen Novolake, die in der Regel in Kombination mit Naphthochinondiaziden als photoaktive Komponenten -eingesetzt werden. Zwar lassen Novolake nach bildmäßiger Belichtung mit kurzwelliger Strahlung in den belichteten Bereichen eine Erhöhung der Löslichkeit gegenüber wäßrig-alkalischen Entwicklern erkennen, doch ist ihre Eigenabsorption in dem für die Belichtung gewünschten Wellenlängenbereich unerwünscht hoch.

Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des 4-Hydroxystyrols sowie seiner Alkylderivate, z.B. des 3-Methyl-4-hydroxystyrols, des 2,3- oder 3,5-Dimethyl-4-hydroxystyrols sowie Homo- oder Copolymere anderer Vinylphenole, z. B. des 2- oder 3-Hydroxystyrols oder der Ester oder Amide von Acrylsäure mit phenolischen Gruppen aufweisenden Aromaten. Als Comonomere können polymerisierbare Verbindungen wie Styrol, Methyl(meth)acrylat oder ähnliche eingesetzt werden.

Gemische mit erhöhter Plasmabeständigkeit werden erhalten, wenn zur Herstellung der Bindemittel Silicium enthaltende Vinylmonomere, z. B. Vinyltrimethylsilan, mitverwendet werden. Die Transparenz dieser Bindemittel ist im Deep-UV-Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im Deep-UV-Bereich. Als Comonomere werden auch hier bevorzugt Styrol, substituierte Styrole, Vinylether, Vinylester, Vinylsilylverbindungen oder (Meth)acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierzu zählen beispielsweise Maleinsäureanhydrid und Maleinsäurehalbester.

Die genannten Bindemittel können auch untereinander gemischt werden, sofern sich dadurch die optische Qualität des strahlungsempfindlichen Gemisches nicht verschlechtert. Bindemittelgemische sind jedoch nicht bevorzugt.

Der Anteil des Bindemittels beträgt im allgemeinen 30 bis 95 Gew.-%, bevorzugt 40 bis 90 Gew.-%, besonders bevorzugt 50 bis 85 Gew.-%, jeweils bezogen auf das Gesamtgewicht der festen Anteile des strahlungsempfindlichen Gemisches.

Die Extinktion des Bindemittels bzw. der Kombination von Bindemitteln für Strahlung der Wellenlänge von etwa 220 bis 500 nm sollte weniger als 0,5, bevorzugt weniger als 0,3 µm⁻¹, betragen.

Ferner können den erfindungsgemäßen strahlungsempfindlichen Gemischen gegebenenfalls Farbstoffe, Pigmente, Weichmacher, Netzmittel und Verlaufmittel, aber auch Polyglykole, Celluloseether, z. B. Ethylcellulose, zur Erfüllung spezieller Erfordernisse, wie Flexibilität, Haftung und Glanz, zugesetzt werden.

Soll ein Substrat beschichtet werden, so wird das erfindungsgemäße strahlungsempfindliche Gemisch zweckmäßig in einem Lösemittel oder in einer Kombination von Lösemitteln gelöst. Hierfür besonders geeignet sind Ethylenglykol und Propylenglykol sowie die davon abgeleiteten Mono- und Dialkylether, besonders die Mono- und Dimethylether sowie die Mono- und Diethylether, Ester abgeleitet aus aliphatischen (C₁-C₆)Carbonsäuren und entweder (C₁-C₈)Alkanolen oder (C₁-C₈)Alkandiolen oder (C₁-C₆)Alkoxy-(C₁-C₈)alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkyl-carbonsäureamide, wie N,N-Dimethylformamid und N,N-Dimethylacetamid, aber auch Hexamethylphosphorsäuretriamid, l-Methyl-pyrrolidin-2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Die mit den genannten Lösemitteln hergestellte Lösung hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einer darauf befindlichen strahlungsempfindlichen Schicht aus dem erfindungsgemäßen strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie Glas oder Indium-Zinnoxid, ferner Metallplatten und -folien - beispielsweise aus Aluminium, Kupfer, Zink-, Bimetall- und Trimetallfolien, aber auch elektrisch nichtleitende Folien, die mit Metallen bedampft sind und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Der gleiche Effekt läßt sich mit einer haftvermittelnden Zwischenschicht erreichen. Bei Silicium- bzw. Siliciumdioxid-Substraten kommen hierfür Haftvermittler vom Aminosilan-Typ, wie z. B. 3-Aminopropyltriethoxysilan oder Hexamethyldisilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert werden, daneben Zink- und Stahlplatten, die gegebenenfalls verchromt werden, sowie Kunststoffolien und Papier.

Das erfindungsgemäße Aufzeichnungsmaterial wird mit aktinischer Strahlung bildmäßig belichtet. Als Strahlungsquellen eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 µm, bevorzugt zwischen 1 und 10 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt und gegebenenfalls zur Beschleunigung der Spaltreaktion erwärmt. Danach behandelt man die Schicht mit einer Entwicklerlösung, die die bestrahlten Bereiche der Schicht löst und entfernt, so daß ein Abbild der bei der bildmäßigen Bestrahlung verwendeten Vorlage auf der Substratoberfläche verbleibt.

Als Entwickler eignen sich besonders wäßrige Lösungen, die Silikate, Metasilikate, Hydroxide, Hydrogen- und Dihydrogenphosphate, Carbonate oder Hydrogencarbonate von Alkalimetall-, Erdalkalimetall- und/oder Ammoniumionen enthalten, aber auch Ammoniak und dergleichen. Metallionenfreie Entwickler werden in den EP-A 0 023 758, 0 062 733 und 0 097 282 sowie den US-A 4 141 733, 4 628 023 und 4 729 941 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden bevorzugt verwendet. Den Entwicklern können geringe Mengen eines Netzmittels zugesetzt sein, um die Ablösung der löslichen Bereiche der Schicht zu erleichtern.

Die entwickelten Schichtstrukturen können nachgehärtet werden. Dies geschieht im allgemeinen durch Erhitzen auf einer hot plate bis zu einer Temperatur unterhalb der Fließtemperatur und anschließendes ganzflächiges Belichten mit dem UV-Licht einer Xenon-Quecksilber-Dampflampe (Bereich von 200 bis 250 nm). Durch die Nachhärtung werden die Bildstrukturen vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht in hoher Dosis erfolgen.

Verwendung findet das erfindungsgemäße strahlungsempfindliche Gemisch bei der Herstellung von integrierten Schaltungen oder von einzelnen elektrischen Bausteinen mit lithographischen Prozessen, da sie eine hohe Lichtempfindlichkeit aufweisen, besonders bei Bestrahlung mit Licht einer Wellenlänge zwischen 190 bis 300 nm. Da die Gemische bei Belichtung sehr gut ausbleichen, lassen sich feinere Strukturen erzielen als dies mit den bekannten Gemischen möglich ist. Die entwickelte Resistschicht dient dabei als Maske für die folgenden Prozeßschritte. Solche Schritte sind z. B. das Ätzen des Schichtträgers, das Implantieren von Ionen in den Schichtträger oder das Abscheiden von Metallen oder anderen Materialien auf dem Schichtträger.

Die nachstehend beschriebenen Beispiele illustrieren die Erfindung, sollen aber nicht beschränkend wirken. Im Folgen steht Gt für Gewichtsteile und Vt für Volumenteile, die sich zu Gewichtsteilen wie g zu cm³ verhalten.

### Herstellungsbeispiel 1

Stufe 1: Zu 280 Gt Aluminiumtrichlorid in 250 Vt Methylenchlorid wurden bei 15°C 88 Gt Acetylchlorid und 128 Gt 2,3-Dimethyl-crotonsäure-methylester zugetropft. Die Lösung wurde 3 Stunden zum Rückfluß erhitzt und nach Abkühlen auf Eis gegeben. Nach Abtrennung der organischen Phase wurde die verbliebene Mischung mit 500 Vt Methylenchlorid ausgerührt. Die vereinigten organischen Phasen wurden mit Wasser gewaschen und anschließend langsam mit einer Lösung aus 76 Gt Hydroxylamin-hydrochlorid in 200 Vt Wasser versetzt. Bei der einsetzenden Erwärmung destillierte das Methylenchlorid ab. Die Lösung wurde 3 Stunden auf 120°C Badtemperatur erwärmt. Nach dem Abkühlen wurde sie dann mit n-Hexan extrahiert. Die verbliebene wäßrige Lösung wurde mit 5%iger Natriumhydroxidlösung auf pH 5 eingestellt, der ausfallende Niederschlag abgesaugt, mit Wasser verrieben, erneut abgesaugt und getrocknet. Es wurden 82 Gt 1-Hydroxy-3,4,6-trimethyl-2-pyridon mit einem Schmelzpunkt von 130°C erhalten.
Stufe 2: Zu einer auf 5°C gekühlten Lösung aus 5,0 Gt der vorstehend beschriebenen Verbindung und 6,8 Gt 4-Fluorbenzolsulfonylchlorid in 60 Vt Methylenchlorid wurde unter Rühren eine Lösung aus 3,4 Gt Triethylamin in 20 Vt Methylenchlorid so langsam zugetropft, daß die vorgegebene Temperatur konstant blieb. Die Lösung wurde auf Raumtemperatur erwärmt und 72 Stunden gerührt. Dann wurde die organische Phase mit Wasser gewaschen, getrocknet und eingeengt. Es wurden 10,8 Gt eines Rohprodukts mit einem Schmelzpunkt von 120°C erhalten. Dieses wurde erneut in Methylenchlorid gelöst und auf eine Kieselgelsäule gegeben; als Laufmittel wurde Methylenchlorid verwendet. Die vereinigten Produktfraktionen wurden eingeengt. Man erhielt 8,6 Gt 1-(4-Fluorbenzolsulfonyloxy)-3,4,6-trimethyl-2-pyridon mit einem Schmelzpunkt von 123°C.

| | | | | |
|---|---|---|---|---|
| Analyse: (311,34) | ber. | C 54,01% | H 4,53% | N 4,50% |
| | gef. | C 53,9% | H 4,7% | N 4,6%. |

### Herstellungsbeispiel 2

1. Stufe: Zu einer Suspension von 532 Gt Aluminiumtrichlorid in 250 Vt Ethylenchlorid und 282 Gt Chloracetylchlorid wurden bei 50 bis 60°C 230 Gt 3-Methylcrotonsäure-methylester so zugegeben, daß die Temperatur gerade gehalten wurde. Anschließend wurde eine Stunde auf 65 bis 70°C erhitzt und auf Eis gegossen. Die wäßrige Phase wurde mit Methylenchlorid extrahiert und die organische Phase mit Wasser und gesättigter Natriumhydrogencarbonatlösung gewaschen. Nach Trocknung über Natriumsulfat wurde fraktioniert destilliert. Ausbeute: 280 Gt (74%), Sdp. 120 bis 122°C/5 Torr.
2. Stufe: 382 Gt des vorstehend beschriebenen Produkts wurden in einer Mischung aus 1000 Vt Eisessig und 10 Vt konzentrierter Schwefelsäure gelöst und zum Sieden erhitzt. Über eine kurze Kolonne wurde die berechnete Menge Methylacetat abdestilliert. Anschließend wurde der Eisessig im Vakuum entfernt und der Rückstand in Eiswasser gegeben, wobei das Pyron kristallisierte. Zur weiteren Reinigung kann das abgetrennte Produkt bei 116 bis 117°C/2 Torr destilliert werden. Nach Umkristallisation aus Tetrachlorkohlenstoff erhielt man 296 Gt 6-Chlormethyl-4-methyl-2-pyron. Ausbeute: 93%, Fp. 78°C.
3. Stufe: 320 Gt des vorstehend beschriebenen Produkts wurden zusammen mit 540 Gt Triphenylphosphin und 1500 Vt Acetonitril 8 Stunden zum Rückfluß erhitzt. Die Mischung wurde in Eis gekühlt und das ausgefallene Produkt abgesaugt. Die Mutterlauge wurde eingeengt, wobei weiteres Produkt ausfiel, das abgesaugt wurde. Es wurden 799 Gt (4-Methyl-6-oxo-6H-pyron-2-ylmethyl)-triphenyl-phosphoniumchlorid erhalten.
4. Stufe: 106 Gt des vorstehend beschriebenen Produkts wurden zusammen mit 35,5 Gt 4-Chlorbenzaldehyd in 200 Vt Methanol gelöst. Dazu wurde eine Lösung aus 6 Gt Natrium in 150 Vt Methanol gegossen, wobei sich die Mischung vorübergehend rot färbte und stark exotherm reagierte. Es wurde 6 Stunden bei Raumtemperatur gerührt, auf -25°C gekühlt und das ausgefallene Produkt abgesaugt. Dieses wurde mit gekühltem Methanol gewaschen, mit Wasser verrührt und erneut abgesaugt. Es wurden 26 Gt 6-(4-Chlorstyryl)-4-methyl-2-pyron erhalten, das aus Acetontril umkristallisiert werden kann. Fp. 144°C.
5. Stufe: 22,5 Gt des vorstehend beschriebenen Produkts wurden mit 9 Gt Hydroxylaminhydrochlorid und 110 Gt 2-Aminopyridin auf etwa 70°C erwärmt. Die Mischung wurde 72 Stunden bei dieser Temperatur belassen, wobei nach 3, 18, 30 und 42 Stunden jeweils 3,3 Gt Hydroxylamin-hydrochlorid nachdosiert wurden. Die erkaltete Mischung wurde in Methylenchlorid aufgenommen und mit verdünnter Salzsäure und Wasser gewaschen. Die organische Phase wurde in einer Lösung aus 10 Gt Natriumhydroxid in 700 Vt entionisiertem Wasser aufgerührt, das entstandene Natriumsalz abfiltriert und in 600 Vt heißem Wasser gelöst. Durch Zugabe von Eisessig wurde die wäßrige Lösung auf pH 5 eingestellt und abgekühlt. Das dabei kristallisierende Rohprodukt wurde abgenutscht und getrocknet. Es wurden 15 Gt eines Rohprodukts mit einem Schmelzpunkt von 195°C erhalten, das aus Methylenchlorid umkristallisiert wurde. Es wurden gelbliche Kristalle [6-(4-Chlor-styryl)-1-hydroxy-4-methyl-2-pyridon] mit einem Schmelzpunkt von 205°C erhalten.

| | | | | |
|---|---|---|---|---|
| Analyse: (261,70) | ber. | C 64,25% | H 4,62% | N 5,35% |
| | gef. | C 64,2% | H 4,6% | N 5,4% |

6. Stufe: Zu einer Lösung aus 4 Gt des vorstehend beschriebenen Produkts und 20 Gt Methansulfonylchlorid in 50 Vt Methylenchlorid wurden 1,85 Gt Triethylamin bei 10°C in 20 Vt Methylenchlorid zugetropft. Die Lösung wurde 24 Stunden bei Raumtemperatur nachgerührt, mit Wasser ausgeschüttelt und das Lösemittel abrotiert. Das kristalline Produkt wurde getrocknet, auf eine Silicagelsäule gegeben und mit Methylenchlorid eluiert. Die vereinigten Produktfraktionen ergaben nach Einengen 4,2 Gt 6-(4-Chlor-styryl)-l-methansulfonyloxy-4-methyl-2-pyridon mit einem Zersetzungspunkt von 190°C. Eine Probe wurde aus Acetonitril umkristallisiert und ergab ein Produkt mit einem Schmelzpunkt von 193°C .

| | | | | |
|---|---|---|---|---|
| Analyse: (339,77) | ber. | C 53,02% | H 4,15% | N 4,12% |
| | gef. | C 52,7% | H 4,4% | N 4,2% |

### Herstellungsbeispiel 3

Stufe 1: 11,2 Gt 4,6-Diphenyl-2-pyron wurden zusammen mit 30 Gt 2-Aminopyridin und 10,4 Gt Hydroxylamin-hydrochlorid 22 Stunden bei 80°C gerührt. Nach dem Erkalten wurden 200 Vt Methylenchlorid zugesetzt. Anschließend wurde die organische Phase mit einer Lösung aus 30 Vt konzentrierter Salzsäure und 200 Vt Wasser und dann mit Wasser allein gewaschen, zweimal mit einer Lösung aus 10 Gt Natriumhydroxid und 300 Gt Wasser ausgeschüttelt und die wäßrigen Extrakte durch Zugabe von Eisessig auf pH 4 eingestellt. Der Niederschlag wurde abgesaugt, mit Wasser gewaschen und getrocknet. Die Ausbeute betrug 10,6 Gt l-Hydroxy-4,6-diphenyl-2-pyridon mit einem Schmelzpunkt von 159°C.
Stufe 2: Eine auf 5°C gekühlte Lösung aus 5,0 Gt der vorstehend beschriebenen Verbindung und 4,64 Gt 4-Chlorbenzolsulfonylchlorid in 50 Vt Methylenchlorid wurde unter Rühren mit einer Lösung aus 2,1 Gt Triethylamin in 20 Vt Methylenchlorid so langsam versetzt, daß die Temperatur konstant blieb. Die Lösung wurde auf Raumtemperatur erwärmt und 120 Stunden gerührt. Dann wurde die organische Phase mit Wasser gewaschen, getrocknet und eingeengt. Es wurden 8,6 Gt eines Rohprodukts erhalten. Dieses wurde zweimal in heißem Diisopropylether digeriert und abgesaugt. Anschließend wurde aus Acetonitril umkristallisiert. Es wurden 7,1 Gt 1-(4-Chlor-benzolsulfonyloxy)-4,6-diphenyl-2-pyridon erhalten. Die Verbindung wies einen Zersetzungspunkt von 165°C auf.

| | | | | |
|---|---|---|---|---|
| Analyse: (437,91) | ber. | C 63,08% | H 3,68% | N 3,20% |
| | gef. | C 63,3% | H 3,7% | N 3,3%. |

### Herstellungsbeispiel 4

Stufe 1: 41,4 Gt 6-Cyclohexyl-l-hydroxy-4-methyl-2-pyridon wurden in 220 Gt konzentrierter Schwefelsäure gelöst und innerhalb 1 Stunde unter Eiskühlung mit 18 Gt Natriumnitrat versetzt. Die Lösung wurde 7 Stunden bei 0°C nachgerührt, auf Eis gegeben und mit Methylenchlorid extrahiert. Die organische Phase wurde mehrfach mit Wasser gewaschen, getrocknet, filtriert und eingeengt. Der Rückstand wurde aus Methanol umgelöst, ausgefällt und anschließend aus Tetrachlorkohlenstoff umkristallisiert. Es wurden 11,6 Gt des in 3-Stellung nitrierten Produkts mit einem Schmelzpunkt von 160°C erhalten.
Stufe 2: Eine auf 5°C gekühlte Lösung aus 6,0 Gt der vorstehend beschriebenen Verbindung und 3,0 Gt Methansulfonylchlorid in 50 Vt Methylenchlorid wurde unter Rühren mit einer Lösung aus 2,6 Gt Triethylamin in 20 Vt Methylenchlorid so langsam versetzt, daß die Temperatur konstant blieb. Die Lösung wurde auf Raumtemperatur erwärmt und 100 Stunden gerührt. Dann wurde die organische Phase mit Wasser gewaschen, getrocknet und eingeengt. Es wurden 8,3 Gt eines Rohprodukts mit einem Schmelzpunkt von etwa 170°C erhalten. Dieses wurde in Methylenchlorid gelöst und mit Methylenchlorid als Laufmittel über eine Kieselgelsäule chromatographiert. Die erhaltenen Fraktionen wurden eingeengt, wobei 7,2 Gt 6-Cyclohexyl-1-methansulfonyloxy-4-methyl-3-nitro-2-pyridon erhalten wurden. Die Verbindung schmolz bei 169°C.

| | | | | |
|---|---|---|---|---|
| Analyse: (330,37) | ber. | C 47,26% | H 5,49% | N 8,48% |
| | gef. | C 47,1% | H 5,5% | N 8,5%. |

### Herstellungsbeispiel 5

Stufe 1: 50 Gt 1-Hydroxy-4,6-dimethyl-2-pyridon wurden zusammen mit 131 Gt Benzolsulfinsäurenatriumsalz, 24 Gt Paraformaldehyd und 250 Gt Eisessig 8 Stunden bei 130°C gerührt. Nach Abkühlen wurde das ausgefallene Produkt abgesaugt, mit Wasser und Methanol gewaschen und getrocknet.
Stufe 2: 6,0 Gt Natrium wurden in 90 Gt Methanol gelöst und mit 27 Gt der vorstehend beschriebenen Verbindung versetzt. Die Lösung wurde etwa 120 Stunden bei 80°C gerührt. Die erkaltete Mischung wurde vom Lösemittel befreit in Wasser gelöst und mit konzentrierter Salzsäure auf pH 3 eingestellt. Die Ausfällung wurde abfiltriert und die verbliebene Mutterlauge mit Methylenchlorid extrahiert. Die organische Phase wurde gewaschen, getrocknet und eingeengt. Der Rückstand wurde aus Methanol umkristallisiert und ergab 10,2 Gt des gewünschten Produkts mit einem Schmelzpunkt von 120°C.
Stufe 3: Eine auf 5°C gekühlte Lösung aus 6,0 Gt der vorstehend beschriebenen Verbindung und 3,4 Gt Methansulfonylchlorid in 50 Vt Methylenchlorid wurde unter Rühren mit einer Mischung aus 3,0 Gt Triethylamin in 20 Vt Methylenchlorid so langsam versetzt, daß die vorgegebene Temperatur konstant blieb. Die Mischung wurde auf Raumtemperatur erwärmt und 80 Stunden gerührt. Dann wurde die organische Phase mit Wasser gewaschen, getrocknet und eingeengt. Es wurden 10,2 Gt eines viskosen Rohprodukts erhalten. Dieses wurde in Methylenchlorid gelöst und mit Methylenchlorid als Laufmittel über eine Kieselgelsäule chromatographiert. Die erhaltenen Fraktionen wurden eingeengt, wobei 5,9 Gt rohes 1-Methansulfonyloxy-3,5-bis-methoxymethyl-4,6-dimethyl-2-pyridon erhalten wurden. Nach dem Umkristallisieren aus Diisopropylether verbleiben 4,8 Gt Reinprodukt, das bei 73°C schmolz.

| | | | | |
|---|---|---|---|---|
| Analyse: (305,36) | ber. | C 47,20% | H 6,27% | N 4,59% |
| | gef. | C 46,9% | H 6,6% | N 4,6%. |

### Herstellungsbeispiel 6

Stufe 1: Zu 28 Gt O-Benzylhydroxylamin und 23,7 Gt Triethylamin in 200 Vt Methylenchlorid wurde innerhalb von 20 Minuten bei einer Temperatur von 20°C eine Mischung aus 23,6 Gt Cyanessigsäurechlorid in 25 Gt Methylenchlorid getropft. Nachdem die Lösung eine Stunde lang nachgerührt worden war, wurde sie mit Wasser gewaschen, getrocknet und eingeengt. Es wurden 45 Gt N-Benzyloxy-2-cyan-acetamid erhalten.
Stufe 2: 24 Gt des vorstehend beschriebenen Produkts, 12,7 Gt Acetylaceton und 1 Gt Diethylamin wurden in 50 Vt Ethanol gelöst und 1,5 Stunden zum Rückfluß erhitzt. Die Lösung wurde auf -20°C gekühlt und die ausgefallenen Kristalle, die das gewünschte 1-Benzyloxy-3-cyan-4,6-dimethyl-2-pyridon darstellen, abgesaugt.
Stufe 3: 28 Gt des vorstehend beschriebenen Produkts wurden in einem Autoklaven in 400 Vt Methanol gelöst und mit 1 Gt eines 10% Palladium/Bariumsulfat-Katalysators versetzt. Die Mischung wurde bei Raumtemperatur mit Wasserstoff hydriert, wobei 2,8 1 Wasserstoff aufgenommen wurden. Nicht gelöste Bestandteile der Mischung wurden abfiltriert und die Lösung eingeengt. Man erhielt 16,5 Gt 3-Cyan-1-hydroxy-4,6-dimethyl-2-pyridon mit einem Schmelzpunkt von 240°C.
Stufe 4: Eine auf 5^{o}C gekühlte Lösung aus 2,9 Gt der vorstehend beschriebenen Verbindung und 2,3 Gt Methansulfonylchlorid in 50 Vt Methylenchlorid wurde unter Rühren mit einer Lösung aus 2,0 Gt Triethylamin in 20 Vt Methylenchlorid so langsam versetzt, daß die vorgegebene Temperatur konstant blieb. Nach dem Erwärmen auf Raumtemperatur wurde die Lösung noch 100 Stunden weiter gerührt, mit Wasser gewaschen, getrocknet und eingeengt. Es wurden 4,0 Gt eines Rohprodukts mit einem Schmelzpunkt von etwa 150°C erhalten. Dieses wurde in Methylenchlorid gelöst und mit Methylenchlorid als Laufmittel über eine Kieselgelsäule chromatographiert. Die erhaltenen Fraktionen wurden eingeengt, wobei 3,2 Gt rohes 3-Cyan-1-methansulfonyloxy-4,6-dimethyl-2-pyridon erhalten wurden. Nach Umkristallisieren aus n-Hexan und Trocknen wurden 3,0 Gt Reinprodukt erhalten, das bei 151°C schmolz, sich wieder verfestigte und einen zweiten scharfen Schmelzpunkt bei 167°C aufwies.

| | | | | |
|---|---|---|---|---|
| Analyse: (242,27) | ber. | C 44,62% | H 4,16% | N 11,57% |
| | gef. | C 44,3% | H 4,2% | N 11,4%. |

### Herstellungsbeispiel 7

Stufe 1: Zu 380 Gt Aluminiumtrichlorid in 350 Vt Methylenchlorid wurde innerhalb von zwei Stunden bei etwa 10°C ein Gemisch aus 106 Gt Isobuttersäurechlorid und 137 Gt 3-Methyl-crotonsäure-methylester zugetropft. Die Mischung wurde 15 Stunden zum Rückfluß erhitzt und nach Abkühlen auf Eis zersetzt. Nach Zusatz von weiterem Methylenchlorid wurde die Mischung ausgerührt, die organische Phase abgetrennt, gewaschen und getrocknet. Nach Einengen des Lösemittels wurde der Rückstand im Vakuum destilliert. Ausbeute: 164 Gt 6-Isopropyl-4-methyl-2-pyron, Kp. 95 bis 110^{o}C/1 Torr.
Stufe 2: 16 Gt Hydroxylamin-hydrochlorid wurden in einer Mischung aus 10 Gt Wasser/100 Gt Methanol gelöst und mit 36,8 Gt des vorstehend beschriebenen Produkts versetzt. Nach zweistündigem Rühren bei Raumtemperatur wurden zur Lösung 20 Gt Natriumhydroxid in 30 Gt Wasser gegeben, 1 Stunde nachgerührt, mit 200 Gt Wasser versetzt und mit Methylenchlorid extrahiert. Anschließend wurde die wäßrige Phase auf pH 4 eingestellt und das ausgefallene Produkt (1-Hydroxy-6-isopropyl-4-methyl-2-pyridon) abgenutscht und getrocknet.
Stufe 3: Eine auf 5°C gekühlte Lösung aus 4,0 Gt der vorstehend beschriebenen Verbindung und 3,45 Gt Methansulfonylchlorid in 50 Vt Methylenchlorid wurde unter Rühren mit einer Lösung aus 2,8 Gt Triethylamin in 30 Vt Methylenchlorid so langsam versetzt, daß die vorgegebene Temperatur konstant blieb. Die Mischung wurde auf Raumtemperatur erwärmt und 35 Stunden gerührt. Dann wurde die organische Phase mit Wasser gewaschen, getrocknet und eingeengt. Es wurden 6,2 Gt eines Rohprodukts mit einem Schmelzpunkt von etwa 110°C erhalten. Dieses wurde in Methylenchlorid gelöst und mit Methylenchlorid als Laufmittel über eine Kieselgelsäule chromatographiert. Die erhaltenen Fraktionen wurden eingeengt, wobei 4,9 Gt 6-Isopropyl-1-methansulfonyloxy-4-methyl-2-pyridon erhalten wurden. Nach Umkristallisation aus Diisopropylether wurden 3,9 Gt Produkt erhalten, das bei 113°C schmolz.

| | | | | |
|---|---|---|---|---|
| Analyse: (245,31) | ber. | C 48,96% | H 6,16% | N 5,71% |
| | gef. | C 49,2% | H 6,3% | N 5,6%. |

### Herstellungsbeispiel 8

1. Stufe: Zu 79,3 Gt 6-Chlormethyl-4-methyl-2-pyron (s. Herstellungsbeispiel 2, 2. Stufe) wurden unter Rühren in einer Destillationsapparatur bei 100°C langsam 108 Gt Triethylphosphit zugetropft. Dabei destillierte Ethylchlorid in die Vorlage über. Nachdem die Ethylchlorid-Abspaltung schwächer wurde, wurde die Badtemperatur langsam auf 130°C erhöht und etwa 6 Stunden bei dieser Temperatur nachgerührt. Nach Ablauf wurden weitere 320 Gt 6-Chlormethyl-4-methyl-2-pyron zur Mischung hinzugefügt und langsam 432 Gt Triethylphosphit bei einer Badtemperatur von 140°C zugetropft. Es wurde erneut 9 Stunden bei dieser Temperatur nachgerührt. Nach dem Abkühlen wurden dann anschließend flüchtige Bestandteile der Mischung bei 70°C im ölpumpenvakuum etwa 3 Stunden abdestilliert. Es verblieben 610 Gt 6-Diethoxyphosphorylmethyl-4-methyl-2-pyron als zäher Rückstand, der nach einiger Zeit zu kristallisieren begann.
2. Stufe: Zu einer Mischung aus 45,5 Gt Benzophenon, 65 Gt der vorstehend beschriebenen Verbindung und 200 Vt 1,2-Dimethoxyethan wurde unter Inertgas und intensivem Rühren 7,75 Gt Natriumhydrid (80% Suspension) zugegeben und die Mischung 24 Stunden bei 70°C gerührt. Das Gemisch wurde in Methylenchlorid aufgenommen, mehrmals mit Wasser gewaschen, getrocknet und am Rotationsverdampfer eingeengt. Man erhielt 74,3 Gt eines aus zwei Komponenten bestehenden Rohprodukts, das über eine Kieselgelsäule mit Methylenchlorid als Laufmittel aufgetrennt wurde. Die Fraktionen, die das Produkt mit der höheren Retentionszeit enthielten wurden vereint und eingeengt. Man erhielt 55 Gt kristallines 6-(2,2-Diphenyl-vinyl)-4-methyl-2-pyron, das aus Hexan umkristallisiert werden kann.
3. Stufe: 20 Gt des vorstehend beschriebenen Produkts wurden mit 5,6 Gt Hydroxylaminhydrochlorid und 80 Gt Aminopyridin auf etwa 75°C erwärmt. Die Mischung wurde 58 Stunden bei dieser Temperatur belassen, wobei nach 6, 22 und 32 Stunden jeweils 2,8 Gt Hydroxylamin-hydrochlorid nachdosiert wurden. Die erkaltete Mischung wurde in Methylenchlorid aufgenommen und mit verdünnter Salzsäure und Wasser gewaschen, getrocknet und eingeengt. Der mit 22 Gt anfallende Rückstand wurde aus Acetonitril umkristallisiert. Es wurden 14 Gt eines gelben Produkts [6-(2,2-Diphenyl-vinyl)-1-hydroxy-4-methyl-2-pyridon] mit einem Schmelzpunkt von 169°C erhalten.

| | | | | |
|---|---|---|---|---|
| Analyse: (303,26) | ber. | C 79,18% | H 5,65% | N 4,62% |
| | gef. | C 79,0% | H 5,8% | N 4,5% |

4. Stufe: Zu einer Lösung aus 8 Gt des vorstehend beschriebenen Produkts und 3,5 Gt Methansulfonylchlorid in 70 Vt Methylenchlorid wurden bei 5 bis 10°C 3 Gt Triethylamin in 20 Vt Methylenchlorid zugetropft. Die Mischung wurde 24 Stunden bei Raumtemperatur nachgerührt, mit Wasser ausgeschüttelt und das Lösemittel abrotiert. Der etwa 12,5 Gt betragende viskose Rückstand kristallisierte beim Stehenlassen und wies einen Schmelzpunkt von etwa 130°C auf. Das Rohprodukt wurde über eine Silicagelsäule mit Methylenchlorid eluiert. Die vereinigten Produktfraktionen ergaben nach Einengen 8,2 Gt 6-(2,2-Diphenyl-vinyl)-1-methansulfonyloxy-4-methyl-2-pyridon mit einem Schmelzpunkt von 140°C.

| | | | | |
|---|---|---|---|---|
| Analyse: (381,44) | ber. | C 66,12% | H 5,02% | N 3,67% |
| | gef. | C 65,7% | H 5,1% | N 3,4% |

### Herstellungsbeispiel 9

Stufe 1: 85 Gt (4-Methyl-6-oxo-6H-pyron-2-ylmethyl)-triphenyl-phosphoniumchlorid (s. Herstellungsbeispiel 2, 3. Stufe) und 41,2 Gt Anthracen-9-carbaldehyd wurden in 200 Vt Methanol dispergiert. Dazu wurde unter Rühren ziemlich rasch eine Lösung von 5 Gt Natrium in 100 Vt Methanol zugegeben, wobei sich die Mischung erwärmte. Es wurde 1 Stunde bei etwa 50°C, anschließend 72 Stunden bei Raumtemperatur weitergerührt, anschließend auf -25°C abgekühlt und das ausgefallene Produkt abgesaugt. Das Produkt wurde mit Methanol gewaschen, dann mit Wasser verrührt und erneut abgesaugt. Es wurden 52 Gt 6-(2-Anthracen-9-yl-vinyl)-4-methyl-2-pyron mit einem Schmelzpunkt von etwa 200°C erhalten, das aus Acetonitril umkristallisiert einen Schmelzpunkt von 203°C aufwies.
Stufe 2: 20 Gt des vorstehend beschriebenen Pyrons wurden mit 5,6 Gt Hydroxylaminhydrochlorid und 80 Gt 2-Aminopyridin auf 70°C erwärmt. Die Mischung wurde 72 Stunden bei dieser Temperatur belassen, wobei nach 7, 23 und 32 Stunden jeweils 2,8 Gt Hydroxylaminhydrochlorid nachdosiert wurden. Die erkaltete Mischung wurde in Methylenchlorid aufgenommen und mit verdünnter Salzsäure und Wasser gewaschen. Dabei fiel ein Teil des Produkts aus. Die organische Phase wurde am Rotationsverdampfer eingeengt. Der Rückstand wurde aus Dimethylformamid (DMF) umkristallisiert. Die erhaltenen Kristalle wurden zusammen mit dem ausgefallenen Produkt erneut aus DMF umkristallisiert und mit Methanol gewaschen. Man erhielt 12,6 Gt eines analysenreinen orangefarbenen Pulvers [6-(2-Anthracen-9-yl-vinyl)-1-hydroxy-4-methyl-2-pyridon], das einen Schmelzpunkt > 260°C aufwies.

| | | | | |
|---|---|---|---|---|
| Analyse: (327,39) | ber. | C 80,71% | H 5,24% | N 4,28% |
| | gef. | C 80,9 % | H 5,4 % | N 4,3 % |

3. Stufe: 4,5 Gt der vorstehend beschriebenen Verbindung und 1,83 Gt Methansulfonylchlorid wurden in 50 Vt Methylenchlorid gelöst und auf 5°C gekühlt. Dazu wurde eine Mischung von 1,6 Gt Triethylamin in 20 Vt Methylenchlorid langsam zugetropft. Es wurde 3 Tage bei Raumtemperatur nachgerührt. Die organische Phase wurde mit Wasser gewaschen, getrocknet und das Lösemittel am Rotationsverdampfer abgezogen. Der Rückstand wurde erneut in Methylenchlorid aufgenommen und über eine Kieselgelsäule mit Methylenchlorid als Laufmittel eluiert. Die deutlich erkennbare Hauptfraktion wurde gesammelt, vom Lösemittel befreit und das verbliebene schaumartige Produkt mit warmen Diisopropylether verrührt. Nach Trocknung wurden 1,9 Gt 6-(2-Anthracen-9-yl-vinyl)-1-methansulfonyloxy-4-methyl-2-pyridon erhalten, das sich bei einer Temperatur von 180°C unter Verpuffung zersetzte.

| | | | | |
|---|---|---|---|---|
| Analyse: (405,48) | ber. | C 68,13% | H 4,72% | N 3,46% |
| | gef. | C 68,1 % | H 4,9 % | N 3,3 % |

### Herstellungsbeispiel 10

Stufe 1: 26 Gt 6-Diethoxyphosphorylmethyl-4-methyl-2-pyron (s. Herstellungsbeispiel 8, 1. Stufe) und 17,4 Gt 4-Trifluormethylbenzaldehyd wurden in 80 Vt 1,2-Dimethoxyethan gelöst. Unter Stickstoff wurden dann portionsweise 3,2 Gt einer 80% Natriumhydrid-Dispersion derart zugefügt, daß sich die Reaktionsmischung nicht über 50°C erwärmte. Sie wurde 18 Stunden bei dieser Temperatur nachgerührt und nach dem Abkühlen mit Methylenchlorid verdünnt. Die Lösung wurde mehrmals mit Wasser gewaschen, getrocknet und eingeengt. Es verblieben 26,9 Gt eines kristallinen Pulvers, das über eine Kieselgelsäule mit Methylenchlorid als Laufmittel eluiert wurde. Aus der Hauptfraktion wurden nach Einengen 18,9 Gt eines Pulvers vom Schmelzpunkt 155°C erhalten, das sich als das gewünschte analysenreine 4-Methyl-6-(4-trifluormethyl-styryl)-2-pyron erwies.
Stufe 2: 15 Gt des vorstehend beschriebenen Produkts, 45 Gt Imidazol, 5 Gt N-Methylpyrrolidon und 5,6 Gt Hydroxylamin-hydrochlorid wurden unter Rühren 55 Stunden auf 75°C erwärmt. Nach 8, 24 und 32 Stunden Reaktionszeit wurden je 2,8 Gt Hydroxylamin-hydrochlorid nachdosiert. Die erkaltete Mischung wurde in Methylenchlorid aufgenommen, mit Wasser gewaschen, getrocknet und eingeengt. Es wurden 14,6 Gt eines Rohprodukts erhalten, das aus Ethylenglykolmonomethylether umkristallisiert wurde. Das auskristallisierte l-Hydroxy-4-methyl-6-(4-trifluormethyl-styryl)-2-pyridon wies einen Schmelzpunkt von 230°C auf.

| | | | | | |
|---|---|---|---|---|---|
| Analyse: (295,28) | ber. | C 61,02% | H 4,10% | F 19,30% | N 4,74% |
| | gef. | C 61,3% | H 4,1% | | |

Stufe 3: 1,8 Gt der vorstehend beschriebenen Verbindung und 1,9 Gt 4-Brombenzolsulfonylchlorid wurden in 40 Vt Methylenchlorid gelöst und auf 5°C gekühlt. Dazu wurde eine Mischung von 1,0 Gt Triethylamin in 5 Vt Methylenchlorid langsam zugetropft. Es wurde 66 Stunden bei Raumtemperatur nachgerührt. Die organische Phase wurde mit Wasser gewaschen, getrocknet und das Lösemittel am Rotationsverdampfer abgezogen. Der Rückstand (3,2 Gt) wurde erneut in Methylenchlorid aufgenommen und über eine Kieselgelsäule mit Methylenchlorid/Methanol (99/1) als Laufmittel eluiert. Die deutlich erkennbare Hauptfraktion wurde gesammelt, vom Lösemittel befreit und das verbliebene schaumartige Produkt mit warmen Diisopropylether verrührt, wobei Kristallisation des Produkts eintrat. Nach Trocknung wurden 2,2 Gt 1-(4-Brombenzolsulfonyloxy)-4-methyl-6-(4-trifluormethyl-styryl)-2-pyridon, das bei einer Temperatur von 158°C schmolz, erhalten.

| | | | | | |
|---|---|---|---|---|---|
| Analyse: (514,33) | ber. | C 49,04% | H 2,94% | N 2,72% | F 11,08% |
| | gef. | C 48,6 % | H 3,1 % | N 2,7 % | |

Auf analoge Weise lassen sich die auch die Verbindungen 11 bis 75 in Tabelle I herstellen. Einige der aufgeführten Verbindungen und ihr Herstellungsverfahren werden in der gleichzeitig eingereichten Patentanmeldung Hoe 3082 eingehend beschrieben.

### Anwendungsbeispiele

Diese Beispiele 1 bis 20 belegen die Eignung des erfindungsgemäßen Gemisches für Aufzeichnungsmaterialien in der Mikrolithographie unter Verwendung von Strahlung unterschiedlicher Energie. Anhand der Vergleichsbeispiele 21 und 22 wird die Überlegenheit der erfindungsgemäßen Gemische gegenüber dem Stand der Technik belegt. Die Beispiele 23 und 24 dokumentieren die Anwendbarkeit des Gemisches in gedruckten Schaltungen und Flachdruckplatten. Anhand der Beispiele 25 bis 75 wird die prinzipielle Strahlungsempfindlichkeit der in den im Anhang aufgeführten Verbindungen demonstriert.

### Beispiel 1

Es wurde eine Beschichtungslösung hergestellt aus

| | |
|---|---|
| 7,5 Gt | eines Kresol-Formaldehyd-Novolaks mit einem Erweichungsbereich von 105 bis 120^{o}C, |
| 2,5 Gt | Piperonal-bis-(butoxyethyl)-acetal, hergestellt analog dem Herstellungsbeispiel 1 der EP-A 312 751, und |
| 0,7 Gt | 6-(4-Chlor-styryl)-1-methansulfonyloxy-4-methyl-2-pyridon in |
| 42 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Wafer bei 3.100 Umdrehungen aufgeschleudert. Nach 1 min Trocknen bei 100^{o}C auf der hot plate betrug die Schichtdicke 1,10 µm.

Das Aufzeichnungsmaterial wurde bildmäßig unter einer Vorlage mit der Strahlung einer Xenon-Quecksilberdampflampe bei 365 nm mit einer Energie von 115 mJ/cm² belichtet und 2 min auf 90°C erwärmt.

Entwickelt wurde das Aufzeichnungsmaterial mit einem 0,3 n alkalischen Entwickler folgender Zusammensetzung:

| | |
|---|---|
| 5,3 Gt | Natriummetasilikat x 9 H₂O, |
| 3,4 Gt | Trinatriumphosphat x 12 H₂O, |
| 0,3 Gt | Natriumdihydrogenphosphat und |
| 91 Gt | vollentsalztes Wasser. |

Nach einer Entwicklungsdauer von 90 s erhielt man ein fehlerfreies Abbild der Maske mit steilen Resistflanken, wobei auch Strukturen < 0,7 µm detailgetreu aufgelöst waren. Eine Untersuchung der Flanken der Resistprofile mittels Rasterelektronenmikroskopie belegte, daß diese praktisch senkrecht zur Substratoberfläche ausgerichtet waren.

### Beispiel 2

Es wurde eine Beschichtungslösung hergestellt aus

| | |
|---|---|
| 7,5 Gt | eines Copolymeren aus Styrol/p-Hydroxystyrol (20/80) mit einem mittleren Molekulargewicht von 32.000, |
| 2,5 Gt | 3,4-Dimethoxybenzaldehyd-bis(phenoxyethyl)acetal, hergestellt analog dem Herstellungsbeispiel 1 der EP-A 312 751, und |
| 0,7 Gt | (4-Fluor-benzolsulfonyloxy)-3,4,6-trimethyl-2-pyridon in |
| 42 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Wafer bei 3.000 Umdrehungen aufgeschleudert. Nach 1 min Trocknen bei 100°C auf der hot plate betrug die Schichtdicke 1,08 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 88 mJ/cm² belichtet, 1 min auf 100°C erwärmt und anschließend mit dem in Beispiel 1 beschriebenen Entwickler verarbeitet.

Nach einer Entwicklungsdauer von 90 s erhielt man ein fehlerfreies Abbild der Maske mit hoher Flankenstabilität, wobei hier Strukturen < 0,55 µm detailgetreu aufgelöst waren.

### Beispiel 3

Ein entsprechend Beispiel 2 hergestellter Wafer wurde unter einer Vorlage mit UV-Licht eines KrF-Excimer-Lasers mit einer Wellenlänge von 248 nm mit einer Energie von 108 mJ/cm² bestrahlt. Nach der Entwicklung wurde ähnlich wie in Beispiel 2 ein originalgetreues Abbild der Vorlage erhalten, in dem auch Strukturen im Submikronbereich detailgetreu wiedergegeben waren.

### Beispiel 4

Der Versuch von Beispiel 1 wurde wiederholt, jedoch wurde UV-Licht einer Wellenlänge von 436 nm verwendet. Um ein kantenscharfes Abbild der Vorlage zu erhalten mußte eine Belichtungsenergie von 135 mJ/cm² eingesetzt werden.

### Beispiel 5

Es wurde eine Beschichtungslösung hergestellt aus

| | |
|---|---|
| 7,5 Gt | eines 1:1-Copolymeren aus Styrol und Male-imid mit einem Erweichungsbereich von 165 bis 180^{o}C, |
| 2,5 Gt | Benzaldehyd-bis(phenoxyethyl)acetal, her-gestellt analog dem Herstellungsbeispiel 1 der DE-A 37 30 787, und |
| 0,7 Gt | 6-(4-Chlor-styryl)-1-methansulfonyloxy-4-methyl-2-pyridon in |
| 42 Gt | Propylenglykol-monomethylether-acetat. |

Die Lösung wurde durch einen Filter mit einem Porendurchmesser von 0,2 µm filtriert und auf einen mit einem Haftvermittler (Hexamethyldisilazan) behandelten Wafer bei 3.500 Umdrehungen aufgeschleudert. Nach 1 min Trocknen bei 100°C auf der hot plate betrug die Schichtdicke 1,00 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 100 mJ/cm² belichtet. Anschließend wurde das belichtete Material 15 min bei Raumtemperatur gelagert.

Entwickelt wurde das Aufzeichnungsmaterial mit einer 0,02 n wäßrigen Tetramethylammoniumhydroxidlösung, wobei die belichteten Bereiche innerhalb von 60 s rückstandsfrei abgelöst wurden.

Ein weiteres Mal wurde ein fehlerfreies Abbild der Maske mit zufriedenstellend steilen Resistflanken erhalten. Der Dunkelabtrag war < 20 nm; Strukturen < 0,6 µm waren detailgetreu aufgelöst.

### Beispiel 6

Es wurde eine Beschichtungslösung hergestellt aus

| | |
|---|---|
| 7,5 Gt | eines 1:1-Copolymeren aus Styrol und Maleimid mit einem Erweichungsbereich von 165 bis 180^{o}C, |
| 2,0 Gt | 3,4-Methylendioxybenzaldehyd-bis(phenoxyethyl)acetal und |
| 0,8 Gt | 6-Cyclohexyl-1-methansulfonyloxy-4-methyl-3-nitro-2-pyridon in |
| 42 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Wafer bei 3.200 Umdrehungen aufgeschleudert. Nach 1 min Trocknen bei 100°C auf der hot plate betrug die Schichtdicke 1,06 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 102 mJ/cm² belichtet und 90 s auf 95°C erwärmt.

Entwickelt wurde das Aufzeichnungsmaterial mit einer 0,02 n wäßrigen Tetramethylammoniumhydroxidlösung, wobei die belichteten Bereiche innerhalb von 90 s rückstandsfrei abgelöst wurden und ein detailgetreues Abbild der Vorlage erhältlich war. Die Kantensteilheit des Bildes betrug mehr als 85°.

### Beispiel 7

Es wurde eine Beschichtungslösung hergestellt aus

| | |
|---|---|
| 7,5 Gt | des in Beispiel 2 beschriebenen Copolymeren, |
| 2,5 Gt | eines Polyorthoesters, hergestellt durch Kondensation von 1 mol 7,7-Bis-hydroxymethylnonanol mit 1 mol Orthoameisensäuretrimethylester, und |
| 0,8 Gt | 1-Methansulfonyloxy-3,5-bis-methoxymethyl-4,6-dimethyl-2-pyridon in |
| 42 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Wafer bei 3.200 Umdrehungen aufgeschleudert. Nach 1 min Trocknen bei 100°C auf der hot plate betrug die Schichtdicke 0,98 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 67 mJ/cm² belichtet und 90 s auf 100°C nacherwärmt.

Entwickelt wurde das Aufzeichnungsmaterial mit einer 0,27 n wäßrigen Tetramethylammoniumhydroxidlösung, wobei die belichteten Bereiche innerhalb von 60 s rückstandsfrei abgelöst wurden und ein detailgetreues Abbild der Vorlage erhältlich war. Linien und Spalten bis herab zu 0,45 µm waren maskengetreu wiedergegeben.

### Beispiel 8

Es wurde eine Beschichtungslösung hergestellt aus

| | |
|---|---|
| 7,5 Gt | eines Kresol-Formaldehyd-Novolaks mit einem Erweichungsbereich von 105 bis 120^{o}C, |
| 2,5 Gt | eines oligomeren Acetals, hergestellt durch Kondensation von 1 mol Benzaldehyd und 1 mol Diethylenglykol, und |
| 0,7 Gt | 1-(4-Brom-benzolsulfonyloxy)-4-methyl-6-(4-trifluormethyl-styryl)-2-pyridon in |
| 42 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Wafer bei 3.100 Umdrehungen aufgeschleudert. Nach 1 min Trocknen bei 100°C auf der hot plate betrug die Schichtdicke 1,05 µm.

Das Aufzeichnungsmaterial wurde bildmäßig unter einer Vorlage mit der UV-Strahlung einer Xenon-Quecksilberdampflampe bei 365 nm mit einer Energie von 85 mJ/cm² belichtet, anschließend 2 min bei Raumtemperatur gelagert und dann für 90 s auf 115°C erwärmt.

Entwickelt wurde das Aufzeichnungsmaterial mit dem in Beispiel 1 beschriebenen Entwickler.

Nach einer Entwicklungsdauer von 90 s erhielt man wiederum ein positives, fehlerfreies Abbild der Maske mit steilen, praktisch vertikalen Resistflanken, wobei auch Strukturen < 0,6 µm detailgetreu aufgelöst waren.

### Beispiel 9

Es wurde eine Beschichtungslösung hergestellt aus

| | |
|---|---|
| 7,5 Gt | eines Copolymeren aus Styrol/p-Hydroxystyrol (20/80) mit einem mittleren Molekulargewicht von 32.000, |
| 2,0 Gt | des in Beispiel 1 eingesetzten Acetals und |
| 0,7 Gt | 6-(2-Anthracen-9-yl-vinyl)-1-methansulfonyloxy-4-methyl-2-pyridon in |
| 42 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Wafer bei 3.000 Umdrehungen aufgeschleudert. Nach 1 min Trocknen bei 100°C auf der hot plate betrug die Schichtdicke 1,1 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 75 mJ/cm² belichtet, wie im vorstehend beschriebenen Beispiel gelagert, getempert und anschließend mit dem in Beispiel 1 beschriebenen Entwickler verarbeitet.

Nach einer Entwicklungsdauer von 120 s erhielt man ein positives fehlerfreies Abbild der Maske mit hoher Flankenstabilität, wobei auch hier Strukturen < 0,6 µm detailgetreu aufgelöst waren.

### Beispiele 10 bis 13

Das vorstehend beschriebene Aufzeichnungsmaterial wurde mit Strahlung einer Wellenlänge von 365, 405, 436, 442 und 488 nm belichtet, wobei Dosen von 105, 115, 98, 95 und 125 mJ/cm² zur qualitativ einwandfreien Wiedergabe der Teststrukturen bis herab zu 0,7 µm notwendig waren.

### Beispiel 14

Ein entsprechend Beispiel 9 hergestellter Wafer wurde unter einer Vorlage mit UV-Licht eines KrF-Excimer-Lasers mit einer Wellenlänge von 248 nm mit einer Energie von 65 mJ/cm² bestrahlt. Der Wafer wurde dann 15 min bei Raumtemperatur gelagert und für etwa 45 s bei 110^{o}C auf der hot plate erwärmt. Nach der Entwicklung wurde ähnlich wie in Beispiel 9 ein originalgetreues positives Abbild der Vorlage erhalten, in dem auch Strukturen im Submikronbereich detailgetreu wiedergegeben waren.

### Beispiel 15

Der Versuch von Beispiel 8 wurde wiederholt, jedoch wurde UV-Licht einer Wellenlänge von 436 nm verwendet. Um ein positives kantenscharfes Abbild der Vorlage zu erhalten mußte eine Belichtungsenergie von 135 mJ/cm² eingesetzt werden.

### Beispiel 16

Es wurde eine Beschichtungslösung hergestellt aus

| | |
|---|---|
| 7,5 Gt | eines 1:1-Copolymeren aus Styrol und Maleimid mit einem Erweichungsbereich von 165 bis 180^{o}C, |
| 2,0 Gt | eines oligomeren N-O-Acetals, hergestellt durch Umsetzung von 1 mol Benzaldehyd-dimethylacetal und 2 mol N-Propyl-carbamidsäure(2-hydroxyethyl)-ester (s. Beispiel 1 der gleichzeitig eingereichten deutschen Patentanmeldung P 41 12 968.7) und |
| 0,7 Gt | 1-(4-Chlor-benzolsulfonyloxy)-4,6-diphenyl-2-pyridon in |
| 42 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Wafer bei 3.100 Umdrehungen aufgeschleudert. Nach 1 min Trocknen bei 100°C auf der hot plate betrug die Schichtdicke 1,05 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 85 mJ/cm² belichtet und dann 2 min auf 105°C erwärmt.

Entwickelt wurde das Aufzeichnungsmaterial mit einer 0,02 n wäßrigen Tetramethylammoniumhydroxidlösung, wobei die belichteten Bereiche innerhalb von 60 s rückstandsfrei abgelöst wurden während die unbelichteten Bereiche praktisch keinerlei Abtrag zeigten.

Ein weiteres Mal wurde ein fehlerfreies positives Abbild der Maske mit zufriedenstellend steilen Resistflanken erhalten. Der Hellabtrag war nach Messung mit einem Schichtdickenmeßgerät der Fa. Rudolph < 10 nm; auch Strukturen < 0,55 µm waren detailgetreu aufgelöst.

### Beispiel 17

Es wurde eine Beschichtungslösung hergestellt aus

| | |
|---|---|
| 10 Gt | eines Terpolymers aus 10% Brenzkatechinmonomethacrylat, 70% Methacrylsäure-(2-tert.-butoxycarbonyloxy-phenyl)ester und 20% Maleimid (hergestellt analog Beispiel 11 der deutschen Patentanmeldung P 41 06 558.1) und |
| 0,3 Gt | 1-(4-Chlor-benzolsulfonyloxy)-4,6-diphenyl-2-pyridon in |
| 30 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Silicium-Wafer bei 4.500 Umdrehungen aufgeschleudert. Nach 1 min Trocknen bei 100°C auf der hot plate betrug die Schichtdicke 1,03 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 85 mJ/cm² belichtet. Der Wafer wird dann 1 min auf 85°C erwärmt.

Entwickelt wurde das Aufzeichnungsmaterial mit einer 0,27 n wäßrigen Tetramethylammoniumhydroxidlösung, wobei die belichteten Bereiche innerhalb von 60 s rückstandsfrei abgelöst wurden während die unbelichteten Bereiche praktisch keinerlei Abtrag zeigten. Strukturen der Testvorlage < 0,5 µm waren detailgetreu aufgelöst.

### Beispiel 18

Das Aufzeichnungsmaterial aus Beispiel 8 wurde mit Synchrotronstrahlung (BESSY, Berlin, 754 MeV) durch eine Gold-auf-Silicium-Maske mit einer Dosis von 225 mJ/cm² bestrahlt. Der experimentelle Aufbau wird bei A. Heuberger, Microelectr. Eng., 3, 535 (1985) beschrieben. Nach Entwicklung mit dem in Beispiel 7 beschriebenen Entwickler und einer Entwicklungsdauer von 70 s erhielt man ein fehlerfreies Bild der Maske bis herab zu Strukturen < 0,4 µm. Die Resistflanken waren praktisch senkrecht zur planaren Substratoberfläche.

### Beispiel 19

Es wurde eine Beschichtungslösung hergestellt aus

| | |
|---|---|
| 9 Gt | eines silylierten Poly-4-hydroxystyrolharzes mit einem mittleren Molekulargewicht von 3500 und einem Silylierungsgrad von 0,6 (hergestellt entsprechend DE-A 38 04 533) und |
| 0,8 Gt | 6-(4-Chlor-styryl)-1-methansulfonyloxy-4-methyl-2-pyridon in |
| 30 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Silicium-Wafer bei 4.700 Umdrehungen aufgeschleudert. Nach 1 min Trocknen bei 100°C auf der hot plate betrug die Schichtdicke 1,08 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 45 mJ/cm² belichtet. Der Wafer wurde dann 10 min bei Raumtemperatur gelagert.

Entwickelt wurde das Aufzeichnungsmaterial mit einer 0,2 n wäßrigen Tetramethylammoniumhydroxidlösung, wobei die belichteten Bereiche innerhalb von 60 s rückstandsfrei abgelöst wurden während die unbelichteten Bereiche praktisch keinerlei Abtrag zeigten. Strukturen der Testvorlage < 0,8 µm waren detailgetreu aufgelöst.

### Beispiel 20

Es wurde eine Beschichtungslösung hergestellt aus

| | |
|---|---|
| 9 Gt | eines Umsetzungsproduktes aus Poly-4-hydroxystyrol mit einem mittleren Molekulargewicht von 6500 und 3,4-Dihydro-2H-pyran (Umsetzungsgrad 74%) und |
| 0,8 Gt | 1-Methansulfonyloxy-3,5-bis-methoxymethyl-4,6-dimethyl-2-pyridon in |
| 30 Gt | Propylenglykol-monomethylether-acetat. |

Die Lösung wurde durch ein Filter mit einem Porendurchmesser von 0,2 µm filtriert und auf einen mit einem Haftvermittler (Hexamethyldisilazan) behandelten Silicium-Wafer bei 4.200 Umdrehungen aufgeschleudert. Nach 1 min Trocknen bei 100°C auf der hot plate betrug die Schichtdicke 0,98 µm.

Das Aufzeichnungsmaterial wurde bildmäßig unter einer Vorlage mit einer Xenon-Quecksilberdampflampe unter Verwendung eines Interferenz filters mit Strahlung von 248 ± 10 nm und einer Energie von 55 mJ/cm² belichtet. Der Wafer wurde dann 1 min auf 100°C erwärmt.

Entwickelt wurde das Aufzeichnungsmaterial mit einer 0,2 n wäßrigen Tetramethylammoniumhydroxidlösung, wobei die belichteten Bereiche innerhalb von 60 s rückstandsfrei abgelöst wurden während die unbelichteten Bereiche praktisch keinerlei Abtrag zeigten. Strukturen der Testvorlage < 0,6 µm waren detailgetreu aufgelöst.

### Beispiele 21 und 22 (Vergleichsbeispiele)

Die Resistformulierung des Beispiels 9 wurde derart abgeändert, daß die dort verwendete säurebildende Verbindung durch die gleiche Menge an Triphenylsulfoniumhexafluorphosphat (Beispiel 21) oder 2-Nitrobenzyltosylat (Beispiel 22) ersetzt wurde. Nach einer Belichtung unter Verwendung eines Interferenz filters mit Strahlung von 248 ± 10 nm und einer Energie von 65 bzw. 95 mJ/cm² sowie Entwicklung mit einem Entwickler der in Beispiel 1 angegebenen Zusammensetzung erhielt man Strukturen, die keine praxisgerechte Bilddifferenzierung zeigten.

Bei Verwendung des Onium-Salzes (Beispiel 21) wurden Strukturen mit sogenanntem "Lackfuß" erhalten, d.h. Resistreste hafteten in den belichteten Bereichen am Substrat an, während bei Verwendung des Tosylesters (Beispiel 22) Oberflächenvernetzungen ("Lippen") sichtbar waren, die die freigelegten Substratflächen teilweise überdachten. In beiden Fällen waren somit keine akzeptablen Strukturierungen erhältlich. Bei Belichtung mit Strahlung einer Wellenlänge von 436 nm wurde in beiden Fällen keine Bilddifferenzierung erreicht.

### Beispiel 23

Für die Herstellung einer Offsetdruckplatte wurde eine mechanisch aufgerauhte und vorbehandelte Aluminiumfolie mit einer Beschichtungslösung nachstehender Zusammensetzung schleuderbeschichtet:

| | |
|---|---|
| 7,5 Gt | eines Kresol-Formaldehyd-Novolaks mit einem Erweichungsbereich von 105 bis 120^{o}C, |
| 2,3 Gt | eines Polyacetals, hergestellt aus 1 mol 2-Ethylbutyraldehyd und 1 mol Triethylenglykol, |
| 0,5 Gt | 6-(4-Chlor-styryl)-1-methansulfonyloxy-4-methyl-2-pyridon und |
| 0,05 Gt | Kristallviolettbase in |
| 90 Gt | Propylenglykol-monomethylether-acetat. |

Nach dem Trocknen der Schicht (Schichtgewicht ca. 2,5 g/m²) wurde unter einer positiven Testvorlage 30 s belichtet, 20 min gelagert und mit einem Entwickler folgender Zusammensetzung entwickelt:

| | |
|---|---|
| 0,5 Gt | Natriumhydroxid, |
| 0,8 Gt | Natriummetasilikat x 9 H₂O, |
| 1,0 Gt | 2-n-Butoxy-ethanol in |
| 97,7 Gt | vollentsalztem Wasser. |

Nach Abspülen mit Wasser wurde die Platte durch Überwischen mit 1%iger Phosphorsäure druckfertig gemacht. Nach dem Einspannen in eine Druckmaschine wurden 62.000 einwandfreie Drucke erhalten.

### Beispiel 24

Die Lösung eines Ätz- und Galvanopositivtrockenresists wurde durch Bereitung nachstehender Zusammensetzung hergestellt:

| | |
|---|---|
| 12,5 Gt | des in Beispiel 1 beschriebenen Novolaks, |
| 10,0 Gt | eines oligomeren aliphatischen Polyacetals mit einem mittleren Molekulargewicht von ca. 1400, hergestellt durch Kondensation von Butyraldehyd mit Diethylenglykol, |
| 0,5 Gt | 6-(4-Methoxy-styryl)-4-methyl-1-(4-nitrobenzolsulfonyloxy)-2-pyridon und |
| 0,1 Gt | Kristallviolett in |
| 30 Gt | Butanon. |

Eine für diesen Zweck übliche Polyethylenterephthalatfolie von 25 µm Dicke wurde mit dieser Lösung beschichtet, so daß sich eine Trockenschichtdicke von 18 µm ergab. Die Oberfläche des trockenen Resistfilms wurde mit einer weiteren Polyethylenterephthalatfolie kaschiert. Der Trockenfilm wurde nach Abziehen der Deckfolie unter Druck und Wärme auf ein Messingblech auflaminiert. Nach Abkühlen und Abziehen der Trägerfolie wurde das Blech durch eine Vorlage hindurch belichtet, wobei nach kurzer Erwärmung ein guter Bildkontrast sichtbar wurde. Die belichteten Stellen wurden mit einem Entwickler der in Beispiel 1 angegebenen Zusammensetzung sprühentwickelt. Das Blech wurde anschließend mit handelsüblicher Eisen-III-chlorid-Lösung bis hin zu den glatten Flanken durchgeätzt. Die erhaltenen Formteile können vor dem Trennen noch weiter bearbeitet werden.

### Beispiele 25 bis 75

Es wurden analog zu Beispiel 9 Beschichtungslösungen hergestellt, in denen die säurebildende Verbindung durch eine gleiche Menge eines anderen erfindungsgemäßen 1-Sulfonyloxy-2-pyridons, nachstehend gekennzeichnet durch seine Verbindungsnummer, ersetzt wurde. Die Beschichtungslösungen wurden ähnlich wie in Beispiel 9 beschrieben auf Aluminiumbleche zu einer Trockenschichtdicke von ca. 2,0 µm aufgeschleudert und dann mit Strahlung unterschiedlicher Wellenlänge (248 ± 10 nm, 365 ± 5 nm, 436 ± 5 nm) durch eine Graukeilmaske mit 15 Stufen und einer Dichtedifferenz von 0,15 pro Stufe belichtet. Anschließend wurden die belichteten Bleche 1 min auf 100°C erwärmt und dann mit dem in Beispiel 1 beschriebenen Entwickler entwickelt. Bei der Entwicklung wurde das Gemisch in den Bereichen, die den Keilstufen mit geringerer Belichtungsmenge entsprechen, vom Entwickler nicht angegriffen, während bei größeren Belichtungsmengen eine vollständige Ablösung des Films erfolgte. Die höchste Stufenzahl, die dem bildmäßig zurückgebliebenen, vom Entwickler nicht völlig abgelösten Stufenkeil entsprach, wurde dann als Maß für die Empfindlichkeit gewertet. Höhere Stufenzahlen bedeuten höhere Empfindlichkeit. Die Ergebnisse sind in Tabelle II zusammengefaßt.

**Tabelle I**

| | |
|---|---|
| 1) | 1-(4-Fluor-benzolsulfonyloxy)-3,4,6-trimethyl-2-pyridon |
| 2) | 6-(4-Chlor-styryl)-1-methansulfonyloxy-4-methyl-2-pyridon |
| 3) | 1-(4-Chlor-benzolsulfonyloxy)-4,6-diphenyl-2-pyridon |
| 4) | 6-Cyclohexyl-1-methansulfonyloxy-4-methyl-3-nitro-2-pyridon |
| 5) | 1-Methansulfonyloxy-3,5-bis-methoxymethyl-4,6-dimethyl-2-pyridon |
| 6) | 3-Cyan-1-methansulfonyloxy-4,6-dimethyl-2-pyridon |
| 7) | 6-Isopropyl-1-methansulfonyloxy-4-methyl |
| 8) | 6-(2,2-Diphenyl-vinyl)-1-methansulfonyloxy-4-methyl-2-pyridon |
| 9) | 6-(2-Anthracen-9-yl-vinyl)-1-methansulfonyloxy-4-methyl-2-pyridon |
| 10) | 1-(4-Brom-benzolsulfonyloxy)-4-methyl-6-(4-trifluormethyl-styryl)-2-pyridon |
| 11) | 1-Methansulfonyloxy-4-methyl-6-(4-nitro-phenyl)-2-pyridon |
| 12) | 1-Benzolsulfonyloxy-6-isopropyl-4-methyl |
| 13) | 1-Ethansulfonyloxy-6-(4-methoxy-phenyl)-4-methyl-2-pyridon |
| 14) | 6-(3-Chlor-4-methoxy-phenyl)-4-methyl-1-(4-nitrobenzolsulfonyloxy)-2-pyridon |
| 15) | 1-Methansulfonyloxy-4-methyl-3-methylmercapto-6-phenyl-2-pyridon |
| 16) | 1-Benzolsulfonyloxy-6-butyl-4-methyl-5-nitro-2-pyridon |
| 17) | 1-Butansulfonyloxy-4-propyl-6-p-tolyl-2-pyridon |
| 18) | 3-Brom-6-(3,4-dichlor-phenyl)-4-methyl-1-(toluol-4-sulfonyloxy)-2-pyridon |
| 19 | 1-Methansulfonyloxy-4-methyl-6-[1]naphthyl-2-pyridon |
| 20) | 5-Cyan-6-cyclohexyl-1-[4-(2-methoxy-ethoxy)-benzolsulfonyloxy]-4-methyl-2-pyridon |
| 21) | 6-(4-Benzyloxy-phenyl)-4-ethyl-3-phenylmercapto-1-trifluormethansulfonyloxy-2-pyridon |
| 22) | 3,5-Dibrom-1-(4-fluor-benzolsulfonyloxy)-4-methyl-6-(2,4,5-trichlor-phenyl)-2-pyridon |
| 23) | 1-Methansulfonyloxy-4,6-dimethyl-2-pyridon |
| 24) | 6-Cyclohexyl-1-(3,4-dichlor-benzolsulfonyloxy)-4-methyl-3-phenyl-2-pyridon |
| 25) | 4-Ethyl-6-[2]naphthyl-1-trifluormethansulfonyloxy-2-pyridon |
| 26) | 3-Brom-1-(4-carboxy-benzolsulfonyloxy)-6-(3,4-dimethoxy-phenyl)-4-methyl-2-pyridon |
| 27) | 5-Ethansulfonyloxy-4-methyl-2,3-dihydro-1H-cyclopenta[c]pyridin-6-on |
| 28) | 3-Allyl-1-benzolsulfonyloxy-4-methyl-6-phenyl-2-pyridon |
| 29) | 6-Benzhydryl-4-methyl-1-trifluormethansulfonyloxy-2-pyridon |
| 30) | 3-Brom-1-(4-methoxy-benzolsulfonyloxy)-4-methyl-6-[2]norbornyl-2-pyridon |
| 31) | 5-Allyl-4-methyl-6-phenyl-1-trifluormethansulfonyloxy-2-pyridon |
| 32) | 4-Methyl-6-phenyl-5-prop-2-inyl-1-(toluol-4-sulfonyloxy)-2-pyridon |
| 33) | 6-(2-Ethyl-pentyl)-1-(1,1,2,3,3,3-hexafluor-propansulfonyloxy)-4-methyl-2-pyridon |
| 34) | 4-Methyl-6-phenethyl-1-(4-trifluormethyl-benzolsulfonyloxy)-2-pyridon |
| 35) | 6-(3-Chlor-4-methoxy-styryl)-1-(4-nitro-benzolsulfonyloxy)-4-phenyl-2-pyridon |
| 36) | 4-Butyl-6-(3,4-dimethoxy-styryl)-1-(4-methoxy-benzolsulfonyloxy)-2-pyridon |
| 37) | 6-[2,2-Bis-(4-methoxy-phenyl)-vinyl]-4-methyl-1-(toluol-4-sulfonyloxy)-2-pyridon |
| 38) | 1-Methansulfonyloxy-4-methyl-6-(4-styryl-styryl)-2-pyridon |
| 39) | 1-Benzolsulfonyloxy-6-[2-(10,11-dihydro-5H-dibenzo[a,d]cyclohepten-5-yl)-vinyl]-4-methyl-2-pyridon |
| 40) | 1-Methansulfonyloxy-4-methyl-6-(6-phenyl-hexa-1,3,5-trienyl)-2-pyridon |
| 41) | 6-(4-Fluor-styryl)-1-methansulfonyloxy-4-methyl-2-pyridon |
| 42) | 1-Benzolsulfonyloxy-4-methyl-6-styryl-2-pyridon |
| 43) | 6-(3,4-Dimethoxy-styryl)-1-ethansulfonyloxy-4-methyl-2-pyridon |
| 44) | 6-(4-Methoxy-styryl)-4-methyl-1-(4-nitro-benzolsulfonyloxy)-2-pyridon |
| 45) | 6-(4-Cyan-styryl)-4-methyl-1-trifluormethansulfonyloxy-2-pyridon |
| 46) | 6-(3-Benzyloxy-styryl)-1-(4-chlor-benzolsulfonyloxy)-4-methyl-2-pyridon |
| 47) | 1-Butansulfonyloxy-6-(3,4-dichlor-styryl)-4-methyl-2-pyridon |
| 48) | 1-(4-Chlor-3-nitro-benzolsulfonyloxy)-6-(5-ethoxy-2-methoxy-styryl)-4-methyl-2-pyridon |
| 49) | 1-(4-Brom-benzolsulfonyloxy)-6-(3-chlor-4-methylstyryl)-4-methyl-2-pyridon |
| 50) | 6-(4-Benzyloxy-3-methoxy-styryl)-1-(4-chlor-benzolsulfonyloxy)-4-methyl-2-pyridon |
| 51) | 1-Isopropansulfonyloxy-4-methyl-6-(4-phenyl-buta-1,3-dienyl)-2-pyridon |
| 52) | 4-Methyl-6-(2-[1]naphthyl-vinyl)-1-(4-nitro-benzolsulfonyloxy)-2-pyridon |
| 53) | 6-[4-(2-Ethoxy-ethoxy)-styryl]-1-methansulfonyloxy-4-methyl-2-pyridon |
| 54) | 6-(2,4-Dimethoxy-3-methyl-styryl)-4-methyl-1-(toluol-4-sulfonyloxy-2-pyridon |
| 55) | 4-Methyl-6-styryl-1-trichlormethansulfonyloxy-2-pyridon |
| 56) | 4-Methyl-6-(2-[2]naphthyl-vinyl)-1-(toluol-4-sulfonyloxy)-2-pyridon |
| 57) | 4-Cyclohexyl-6-(4-methoxy-styryl)-1-methansulfonyloxy-2-pyridon |
| 58) | 3-Cyan-6-(3,4-dimethyl-styryl)-4-methyl-1-(toluol-4-sulfonyloxy)-2-pyridon |
| 59) | 6-[2-(4-Chlor-phenyl)-propenyl]-1-methansulfonyloxy-4-methyl-2-pyridon |
| 60) | 6-(3-Chlor-4-methoxy-styryl)-4-phenyl-1-(4-nitrobenzolsulfonyloxy)-2-pyridon |
| 61) | 4-Butyl-6-(3,4-dimethoxy-styryl)-1-(4-methoxy-benzolsulfonyloxy)-2-pyridon |
| 62) | 6-[2,2-Bis-(4-methoxy-phenyl)-vinyl]-4-methyl-1-(toluol-4-sulfonyloxy)-2-pyridon |
| 63) | 6-(2-Anthracen-9-yl-vinyl)-4-methyl-1-(toluol-4-sulfonyloxy)-2-pyridon |
| 64) | 1-Benzolsulfonyloxy-5-chlor-4-ethyl-6-(4-methoxystyryl)-2-pyridon |
| 65) | 4-Methyl-3-nitro-6-(2-thiophen-2-yl-vinyl)-1-(toluol-4-sulfonyloxy)-2-pyridon |
| 66) | 3-Butylmercapto-1-methansulfonyloxy-6-(4-methoxystyryl)-4-methyl-2-pyridon |
| 67) | 3,5-Dibrom-4-methyl-6-(3-methyl-styryl)-1-(toluol-4-sulfonyloxy)-2-pyridon |
| 68) | 1-Ethansulfonyloxy-3-methoxymethyl-4-methyl-6-(2-[2]naphthyl-vinyl)-2-pyridon |
| 69) | 3,5-Dichlor-6-[2-(6-methoxy-[2]naphthyl)-vinyl]-4-methyl-1-(toluol-4-sulfonyloxy)-2-pyridon |
| 70) | 1-Methansulfonyloxy-4-methyl-6-(2-[1]naphthyl-vinyl)-2-pyridon |
| 71) | 6-(4-Dimethylamino-styryl)-1-methansulfonyloxy-4-methyl-2-pyridon |
| 72) | 6-(2-Benzofuran-2-yl-vinyl)-3-methoxymethyl-4-methyl-1-(toluol-4-sulfonyloxy)-2-pyridon |
| 73) | 6-[2-(5-Brom-thiophen-2-yl)-vinyl]-3,5-dichlor-4-methyl-1-(trifluormethyl-benzolsulfonyloxy)-2-pyridon |
| 74) | 1-Methansulfonyloxy-4-methyl-6-(4-phenyl-styryl)-2-pyridon |
| 75) | 1-Benzolsulfonyloxy-3-brom-6-[4-(4-chlorphenoxy)-styryl]-4-methyl-2-pyridon |
| 76) | 6-[4-(4-Chlorphenylmercapto)-styryl]-1-(4-fluorbenzolsulfonyloxy)-4-methyl-2-pyridon |
| 77) | 6-[4-(4-Chlor-benzyloxy)-styryl]-1-(4-isopropylbenzolsulfonyloxy)-4-methyl-2-pyridon |
| 78) | 6-(4-Chlor-3-trifluormethyl-styryl)-1-(1,1,2,3,3,3-hexafluorpropansulfonyloxy)-4-methyl-2-pyridon |
| 79) | 1-Benzolsulfonyloxy-6-(4-dimethylamino-styryl)-4-methyl-2-pyridon |
| 80) | 6-(4-Allyloxy)-styryl]-1-methansulfonyloxy-4-methyl-2-pyridon |
| 81) | 6-(3,5-Dichlor-4-hexyloxy-styryl)-4-methyl-1-propansulfonyloxy-2-pyridon |
| 82) | 4-Methyl-6-(2-phenyl-2-cyclohexyl-vinyl)-1-(toluol-4-sulfonyloxy)-2-pyridon |
| 83) | 1-(4-Methoxy-benzolsulfonyloxy)-4-methyl-6-(2-phenyl-hex-1-enyl)-2-pyridon |
| 84) | 3-Brom-6-(2-cyclohexyl-vinyl)-4-methyl-1-trifluormethansulfonyloxy-2-pyridon |
| 85) | 4-Ethyl-1-methansulfonyloxy-6-pent-1-enyl-2-pyridon |
| 86) | 1-Methansulfonyloxy-4-methyl-6-(2-methyl enyl)-2-pyridon |
| 87) | 6-Cyclooctylidenmethyl-1-methansulfonyloxy-4-methyl-2-pyridon |
| 88) | 6-Cyclopentylidenmethyl-4-methyl-1-(toluol-4-sulfonyloxy)-2-pyridon |
| 89) | 6-[2-(5-Brom-thiophen-2-yl)-vinyl]-3-methansulfonylamino-1-methansulfonyloxy-4-methyl-2-pyridon |
| 90) | 6-[2-(5-Brom-thiophen-2-yl)-vinyl]-3-isobutyrylamino-4-methyl-1-(toluol-4-sulfonyloxy)-2-pyridon |
| 91) | 1-Ethansulfonyloxy-6-(2-methyl-6-phenyl-hexa-1,3,5-trienyl)-4-methyl-2-pyridon |
| 92) | 6-(4-Cyclohexyloxy-styryl)-1-(1,1,2,3,3,3-hexafluor-propansulfonyloxy)-4-methyl-2-pyridon |
| 93) | 6-(3-Cyclopropyloxy-styryl)-1-methansulfonyloxy-4-methyl-2-pyridon |
| 94) | 6-(2-Benzofuran-2-yl-vinyl)-4-methyl-1-(toluol-4-sulfonyloxy)-2-pyridon |
| 95) | 6-[2-(5-Brom-thiophen-2-yl)-vinyl]-4-methyl-1-(3-trifluormethyl-benzolsulfonyloxy)-2-pyridon |
| 96) | 4-Methyl-6-[2-(5-methyl-furan-2-yl)-vinyl]-1-(naphthalin-2-ylsulfonyloxy)-2-pyridon |
| 97) | 4-Methyl-6-(4-nitro-styryl)-1-octansulfonyloxy-2-pyridon |
| 98) | 1-Hexadecansulfonyloxy-4-methyl-6-(4-nitro-styryl)-2-pyridon |
| 99) | 1-Methansulfonyloxy-4-methyl-6-(4-nitro-styryl)-2-pyridon |
| 100) | 6-(2,2-Di-thiophen-2-yl-vinyl)-1-methansulfonyoxy-4-methyl-2-pyridon |
| 101) | 3-Cyan-6-(2,4-dimethoxy-styryl)-4-methyl-1-trifluormethansulfonyloxy-2-pyridon |
| 102) | 6-(2-Benzofuran-2-yl-vinyl)-4-methyl-3-thiocyanatol-(toluol-4-sulfonyloxy)-2-pyridon |
| 103) | 6-(2-Benzofuran-2-yl-vinyl)-3-brom-1-methansulfonyloxy-4-methyl-2-pyridon |
| 104) | 3,5-Bis-isopropylmercaptomethyl-4-methyl-1-(4-nitro-benzolsulfonyloxy)-6-styryl-2-pyridon |
| 105) | 1-(4-Methoxy-benzolsulfonyloxy)-4-methyl-6-(2,3,4,5,6-pentafluor-styryl)-2-pyridon |
| 106) | 6-(3,5-Dichlor-2,4,6-trimethoxy-styryl)-4-methyl-1-(1-trifluormethyl-2,2,2-trifluor-ethan-sulfonyloxy) -2-pyridon |
| 107) | 6-(3-Brom-2,4,6-trimethoxy-styryl)-1-methansulfonyloxy-4-methyl-2-pyridon |
| 108) | 6-(2-Ferrocenyl-vinyl)-4-methyl-1-(toluol-4-sulfonyloxy)-2-pyridon |
| 109) | 6-[2-(5-Methyl-furan-2-yl)-vinyl]-4-methyl-3-nitro-1-(toluol-4-sulfonyloxy)-2-pyridon |
| 110) | 6-(4-tert.-Butyl-styryl)-4-methyl-5-nitro-1-propansulfonyloxy-2-pyridon |
| 111) | 3,5-Dinitro-6-(4-tert.-butyl-styryl)-4-methyl-1-butansulfonyloxy-2-pyridon |
| 112) | 1-Benzolsulfonyloxy-3-brom-6-(4-butoxy-styryl)-4-methyl-5-nitro-2-pyridon |
| 113) | 1-(4-Brom-benzolsulfonyloxy)-4-methyl-6-(4-trifluormethyl-styryl)-2-pyridon |
| 114) | 6-(3-Chlor-4-phenyl-buta-1,3-dienyl)-1-isopropansulfonyloxy-4-methyl-2-pyridon |
| 115) | 1-Benzolsulfonyloxy-4-methyl-6-[2-(1-benzolsulfonyl-pyrrol-2-yl)-vinyl]-2-pyridon |
| 116) | 6-(10,11-Dihydro-dibenzo[a,d]cyclohept-5-yliden-methyl)-4-methyl-1-(2-thiophen-2-ylsulfonyloxy)-2-pyridon |
| 117) | 1-Benzolsulfonyloxy-4-methyl-6-(4-styryl-styryl)-2-pyridon |
| 118) | 1-Methansulfonyloxy-4-methyl-6-(2-[l]naphthyl-vinyl)-2-pyridon |
| 119) | 1-Methansulfonyloxy-4-methyl-6-(4-phenyl dienyl)-2-pyridon |
| 120) | 6-(4-Dimethylamino-styryl)-1-methansulfonyloxy-4-methyl-2-pyridon |
| 121) | 1-Methansulfonyloxy-6-(4-methoxy-styryl)-4-methyl-2-pyridon |
| 122) | 1-(4-Chlor-benzolsulfonyloxy)-6-(4-methoxy-styryl)-4-methyl-2-pyridon |
| 123) | 1-(4-Chlor-benzolsulfonyloxy)-6-(4-chlor-styryl)-4-methyl-2-pyridon |
| 124) | 1-Ethansulfonyloxy-6-(4-methoxy-styryl)-4-methyl-2-pyridon |
| 125) | 3-Brom-1-methansulfonyloxy-6-(4-methoxy-styryl)-4-methyl-2-pyridon |
| 126) | 1-Isopropansulfonyloxy-6-(4-methoxy-styryl)-4-methyl-2-pyridon |
| 127) | 1-Butansulfonyloxy-6-(4-methoxy-styryl)-4-methyl-2-pyridon |
| 128) | 6-(4-Methoxy-styryl)-4-methyl-1-trifluormethansulfonyloxy-2-pyridon |
| 129) | 6-(4-Methoxy-styryl)-1-(1,1,2,3,3,3-hexafluor-propansulfonyloxy)-4-methyl-2-pyridon |
| 130) | 6-(4-Methoxy-styryl)-4-methyl-1-benzolsulfonyloxy-2-pyridon |
| 131) | 1-(4-Fluor-benzolsulfonyloxy)-6-(4-methoxy-styryl)-4-methyl-2-pyridon |
| 132) | 6-(4-Methoxy-styryl)-4-methyl-1-(4-trifluor-benzolsulfonyloxy)-2-pyridon |
| 133) | 1-Benzolsulfonyloxy-6-(4-methoxy-styryl)-4-methyl-2-pyridon |
| 134) | 6-(4-Chlor-styryl)-1-ethansulfonyloxy-4-methyl-2-pyridon |
| 135) | 3-Brom-6-(4-chlor-styryl)-1-methansulfonyloxy-4-methyl-2-pyridon |
| 136) | 6-(4-Chlor-styryl)-1-isopropansulfonyloxy-4-methyl-2-pyridon |
| 137) | 1-Butansulfonyloxy-6-(4-Chlor-styryl)-4-methyl-2-pyridon |
| 138) | 6-(4-Chlor-styryl)-4-methyl-1-trifluormethansulfonyloxy-2-pyridon |
| 139) | 6-(4-Chlor-styryl)-1-(1,1,2,3,3,3-hexafluor-propansulfonyloxy)-4-methyl-2-pyridon |
| 140) | 1-Benzolsulfonyloxy-6-(4-chlor-styryl)-4-methyl-2-pyridon |
| 141) | 6-(4-Chlor-styryl)-1-(4-fluor-benzolsulfonyloxy)-4-methyl-2-pyridon |
| 142) | 6-(4-Chlor-styryl)-4-methyl-1-(4-trifluormethylbenzol-sulfonyloxy)-2-pyridon |
| 143) | 1-Benzolsulfonyloxy-6-(4-chlor-styryl)-4-methyl-2-pyridon |
| 144) | 1,4-Bis-(4-methyl-2-oxo-6-styryl-2H-pyridin-1-yloxysulfonyl)-butan |
| 145) | 1,3-Bis-[6-(4-methoxy-styryl)-4-methyl-2-oxo-2H-pyridin-1-yloxysulfonyl]-benzol |
| 146) | 1,3-Bis-[3-brom-6-(4-chlor-styryl)-4-methyl-2-oxo-2H-pyridin-1-yloxysulfonyl]-2,4,6-trimethyl-benzol |
| 147) | 1,5-Bis-[6-(4-fluor-styryl)-4-methyl-2-oxo-2H-pyridin-1-yloxysulfonyl]-naphthalin |
| 148) | 2-Chlor-3,5-bis-[4-methyl-6-(4-methyl-styryl)-2-oxo-2H-pyridin-1-yloxysulfonyl]-thiophen |
| 149) | 1-Methansulfonyloxy-2-pyridon |
| 150) | 1-Benzolsulfonyloxy-4-methyl-3-thiocyanato-6-(2,4,4-trimethyl-pentyl)-2-pyridon |
| 151) | 6-Cyclohexyl-3-methansulfonylamino-1-methansulfonyloxy-4-methyl-2-pyridon |
| 152) | 3-Acetylamino-4-methyl-1-(naphthalin-2-ylsulfonyloxy)-6-phenyl-2-pyridon |
| 153) | 1-Methansulfonyloxy-4-methyl-6-phenyl-2-pyridon |
| 154) | 5-Chlor-3,4,6-trimethyl-1-(thiophen-2-ylsulfonyloxy)-2-pyridon |
| 155) | 1-Methansulfonyloxy-4,6-diphenyl-2-pyridon |
| 156) | 1-(4-Chlor-benzolsulfonyloxy)-6-cyclohexyl-4-methyl-2-pyridon |
| 157) | 1-(4-Isopropyl-benzolsulfonyloxy)-4-methyl-6-undecyl-2-pyridon |
| 158) | 1-Methansulfonyloxy-4-methyl-6-(2,3,3-trimethyl-butyl)-2-pyridon |
| 159) | 1-(2-Chlor-5-nitro-benzolsulfonyloxy)-4-methyl-6-(2,4,6-trichlor-phenoxymethyl)-2-pyridon |
| 160) | 6-(4-Chlor-benzyl)-1-(3-chlor-4-methoxy-benzolsulfonyloxy)-4-methyl-2-pyridon |
| 161) | 1-Methansulfonyloxy-4,5,6-triphenyl-2-pyridon |
| 162) | 6-(2,4-Dichlor-phenyl)-1-methansulfonyloxy-4-methyl-2-pyridon |
| 163) | 6-(2-Cyclohexyl-ethyl)-4-methyl-1-pentafluorbenzolsulfonyloxy-2-pyridon |
| 164) | 1-(4-Brom-benzolsulfonyloxy)-4-methyl-6-[2]norbornyl-2-pyridon |
| 165) | 3-Ethyl-1-methansulfonyloxy-4-methyl-6-p-tolyl-2-pyridon |
| 166) | 1-Benzolsulfonyloxy-3,5-dijod-4,6-dimethyl-2-pyridon |
| 167) | 1,3-Bis-(4-methyl-2-oxo-2H-pyridin-1-yloxysulfonyl)-4,6-dichlor-benzol |
| 168) | 6-(2,4-Dichlor-benzyl)-4-methyl-3,5-dinitro-1-(toluol-4-sulfonyloxy)-2-pyridon |
| 169) | 1,3-Bis-(6-cyclohexyl-4-methyl-2-oxo-2H-pyridin-1-yloxysulfonyl)-2,4,6-trimethyl-benzol |
| 170) | 1,4-Bis-(4-methyl-2-oxo-6-phenyl-2H-pyridin-1-yloxysulfonyl)-butan |

**Tabelle II**

| | | Maßzahlen für die Ablösung des Films nach Bestrahlung | | |
|---|---|---|---|---|
| Beispiel | Verbindung | 248 nm | 365 nm | 436 nm |
| 25 | keine | 0 | 0 | 0 |
| 26 | 1 | 8 | 3 | 0 |
| 27 | 2 | 8 | 9 | 10 |
| 28 | 3 | 7 | 5 | 0 |
| 29 | 4 | 8 | 2 | 0 |
| 30 | 5 | 6 | 1 | 0 |
| 31 | 6 | 6 | 1 | 0 |
| 32 | 7 | 6 | 1 | 0 |
| 33 | 8 | 8 | 8 | 5 |
| 34 | 9 | 7 | 7 | 12 |
| 35 | 10 | 8 | 11 | 8 |
| 36 | 12 | 8 | 8 | 1 |
| 37 | 14 | 8 | 10 | 3 |
| 38 | 16 | 5 | 6 | 0 |
| 39 | 18 | 9 | 5 | 0 |
| 40 | 19 | 8 | 11 | 5 |
| 41 | 21 | 11 | 5 | 1 |
| 42 | 23 | 9 | 6 | 0 |
| 43 | 24 | 9 | 5 | 0 |
| 44 | 25 | 12 | 9 | 3 |
| 45 | 27 | 8 | 3 | 0 |
| 46 | 29 | 8 | 6 | 1 |
| 47 | 30 | 8 | 6 | 2 |
| 48 | 31 | 8 | 5 | 5 |
| 49 | 32 | 6 | 3 | 0 |
| 50 | 35 | 9 | 12 | 10 |
| 51 | 37 | 8 | 11 | 6 |
| 52 | 38 | 9 | 12 | 12 |
| 53 | 39 | 7 | 7 | 6 |
| 54 | 40 | 5 | 5 | 8 |
| 55 | 43 | 11 | 14 | 12 |
| 56 | 45 | 9 | 12 | 8 |
| 57 | 47 | 10 | 10 | 7 |
| 58 | 49 | 8 | 8 | 6 |
| 59 | 50 | 10 | 12 | 9 |
| 60 | 51 | 10 | 11 | 13 |
| 61 | 52 | 8 | 11 | 12 |
| 62 | 54 | 9 | 10 | 10 |
| 63 | 56 | 8 | 11 | 11 |
| 64 | 58 | 7 | 9 | 11 |
| 65 | 60 | 9 | 11 | 11 |
| 66 | 62 | 8 | 8 | 7 |
| 67 | 63 | 7 | 7 | 13 |
| 68 | 65 | 8 | 8 | 10 |
| 69 | 66 | 9 | 12 | 9 |
| 70 | 67 | 6 | 9 | 7 |
| 71 | 69 | 8 | 12 | 12 |
| 72 | 71 | 5 | 6 | 6 |
| 73 | 72 | 7 | 9 | 9 |
| 74 | 74 | 10 | 10 | 8 |
| 75 | 76 | 11 | 12 | 10 |

## Patentansprüche

1. Positiv arbeitendes strahlungsempfindliches Gemisch mit
a) einer Verbindung, die unter Einwirkung von aktinischer Strahlung eine starke Säure bildet,
b) einer Verbindung mit mindestens einer durch Säure spaltbaren C-O-C- oder C-O-Si-Bindung und
c) einem in Wasser unlöslichen, in wäßrig-alkalischen Lösungen löslichen oder zumindest quellbaren polymeren Bindemittel,
das dadurch gekennzeichnet ist, daß die Verbindung (a) ein 1-Sulfonyloxy-2-pyridon der allgemeinen Formel I 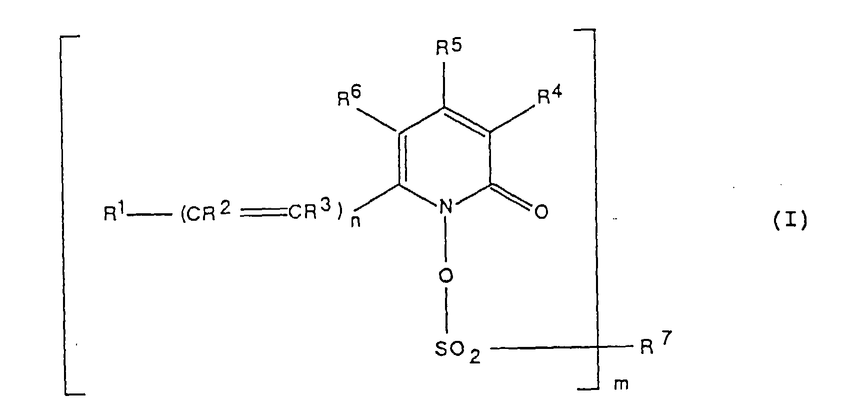 ist, worin
R¹ ein Wasserstoffatom, einen Alkyl-, Cycloalkyl-, Aryl-, Aralkenyl-, Heteroaryl- oder Heteroaralkenylrest,
R² Wasserstoff, Chlor, Brom, einen Alkyl-, Cycloalkyl-, Aryl- oder Heteroarylrest oder
R¹ und R² gemeinsam einen fünf- bis achtgliedrigen Ring ausbilden,
R³ Wasserstoff oder einen Alkylrest,
R⁴ Wasserstoff, Halogen, Nitro, Acylamino, Cyan, Thiocyanato, einen Alkyl-, Alkenyl-, Alkinyl-, Aryl-, Aralkyl-, Alkylthio-, Arylthio- oder Cycloalkylthiorest,
R⁵ Wasserstoff, einen Alkyl- oder Arylrest oder
R⁴ und R⁵ zusammen einen fünf- bis achtgliedrigen Ring ausbilden,
R⁶ Wasserstoff, Halogen, Nitro, Acylamino, Cyan, Thiocyanato, einen Alkyl-, Alkenyl-, Alkoxyalkyl-, Aryl-, Aralkyl-, Alkylthio-, Cycloalkylthio- oder Arylthiorest,
R⁷ einen Alkyl-, Cycloalkyl, per- oder hochfluorierten Alkylrest oder einen Aryl-, Arylalkyl- oder Heteroarylrest oder einen Alkylen- oder Arylenrest
m die Zahl 1 oder 2 und
n eine ganze Zahl von 0 bis 3
bedeuten.

2. Positiv arbeitendes strahlungsempfindliches Gemisch gemäß Anspruch 1, dadurch gekennzeichnet, daß
R¹ ein Alkyl- oder Cycloalkylrest oder ein Arylrest der allgemeinen Formel II 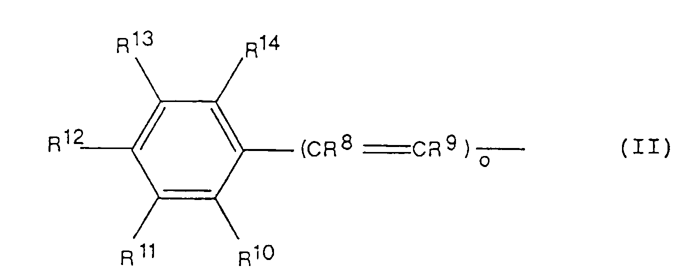 ist, worin
R⁸ und R⁹ gleich oder verschieden sind und Wasserstoff, eine niedere Alkyl- oder Arylgruppe darstellen,
R¹⁰ bis R¹⁴ gleich oder verschieden sind und Wasserstoff, einen Alkyl-, Alkenyl-, Alkoxy-, Alkylthio-, Alkansulfonylrest mit jeweils bis zu 6 Kohlenstoffatomen, einen Cycloalkyloxy-, Cycloalkylthio-, Cycloalkansulfonylrest mit bis zu 8 Kohlenstoffatomen, gegebenenfalls am aromatischen Ring substituierten Phenyl-, Styryl-, Phenoxy-, Phenylthio-, Benzolsulfonyl-, Phenylalkoxy-, Phenylalkylthio-, Phenylalkansulfonylrest mit bis zu 3 Kohlenstoffatomen in der Alkylkette, Hydroxy, Halogen, Trifluormethyl, Nitro, Cyan, Alkoxycarbonyl, Carbamoyl, das gegebenenfalls am Stickstoff durch einen oder zwei Alkylrest(e), die gegebenenfalls zu einem 5- bis 7-gliedrigen Ring verbunden sind, substituiert ist, Sulfamoyl, das gegebenenfalls am Stickstoff durch ein oder zwei Alkylrest(e), die gegebenenfalls zu einem 5- bis 7-gliedrigen Ring verbunden sind, substituiert ist, Alkansulfonyloxy, Arylsulfonyloxy, Acylamino, Alkylamino oder Arylamino bedeuten,
oder zwei der Substituenten R¹⁰ bis R¹⁴, die einander benachbart sind, einen oder zwei weitere ankondensierte Ring(e) bilden, und
o für die Zahl 0 oder 1 steht.

3. Positiv arbeitendes strahlungsempfindliches Gemisch gemäß den Ansprüchen 1 oder 2, dadurch gekennzeichnet, daß R¹ ein 5- oder 6-gliedriger Heterocyclus mit bis zu drei Heteroatomen der allgemeinen Formel III 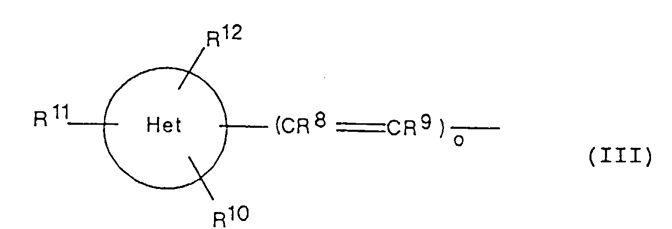 ist.

4. Positiv arbeitendes strahlungsempfindliches Gemisch gemäß den Ansprüchen 1 bis 3, dadurch gekennzeichnet, daß in der allgemeinen Formel I
R¹ ein Ferrocenylrest und
R² Wasserstoff, Chlor, Brom, Alkyl-, Cycloalkyl oder ein Rest der allgemeinen Formeln II oder III ist oder
R¹ und R² gemeinsam einen fünf- bis achtgliedrigen Ring ausbilden,
R³ Wasserstoff oder ein Alkylrest,
R⁴ Wasserstoff, Halogen, Nitro, Acylamino, Cyan, Thiocyanato, ein Alkyl-, Aryl-, Alkylthio-, Arylthio- oder Cycloalkylthiorest,
R⁵ Wasserstoff, ein Alkyl- oder Arylrest ist oder
R⁴ und R⁵ gemeinsam einen fünf- bis achtgliedrigen Ring ausbilden,
R⁶ Wasserstoff, Halogen, Nitro, Acylamino, Cyan, Thiocyanato, ein Alkyl-, Aryl-, Alkylthio-, Arylthio- oder Cycloalkylthiorest,
R⁷ ein Alkyl-, Cycloalkyl-, per- oder hochfluorierten Alkylrest oder ein Aryl-, Arylalkyl- oder Heteroarylrest oder ein Alkylen- oder Arylenrest ist und
n für eine ganze Zahl von 0 bis 3 und
m für die Zahl 1 oder 2 steht.

5. Positiv arbeitendes strahlungsempfindliches Gemisch gemäß Anspruch 1, dadurch gekennzeichnet, daß R⁷ ein Alkylrest mit 1 bis 4 Kohlenstoffatomen, ein hoch- oder perfluorierter Alkylrest mit 1 bis 4 Kohlenstoffatomen oder ein Arylrest der allgemeinen Formel IV 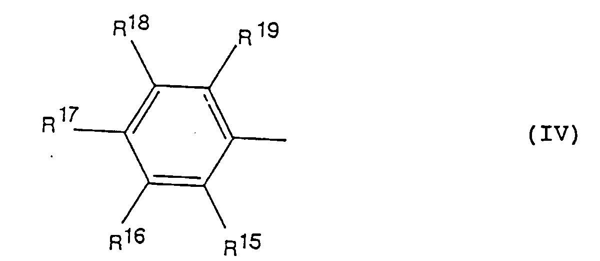 ist, worin R¹⁵ bis R¹⁹ gleich oder verschieden sind und Wasserstoff- oder Halogenatome, die vorzugsweise Fluor, Chlor oder Brom sind, Alkylreste mit bis zu 6 Kohlenstoffatomen, die unsubstituiert oder durch Halogenatome, vorzugsweise Chlor oder Brom, Aryl- oder Aryloxyreste, substituiert sind und in denen einzelne Methylengruppen durch Sauerstoff - oder Schwefelatome ersetzt sein können und wobei jeweils zwei dieser Reste unter Ausbildung eines 5- oder 6-gliedrigen Rings verknüpft sein können, Cycloalkylreste mit bis zu 8 Kohlenstoffatomen, Alkenylreste mit bis zu 6 Kohlenstoffatomen, Aryl- oder Aryloxyreste mit bis zu 10 Kohlenstoffatomen bedeuten und die Gesamtzahl der Kohlenstoffatome der Reste R¹⁵ bis R¹⁹ maximal 12 beträgt.

6. Positiv arbeitendes strahlungsempfindliches Gemisch gemäß Anspruch 1, dadurch gekennzeichnet, daß R⁷ ein Naphthyl- oder Heteroarylrest mit bis zu 10 Kohlenstoffatomen, ein Alkylenrest mit bis zu 6 Kohlenstoffatomen oder ein Arylen- oder Heteroarylenrest mit bis zu 14 Kohlenstoffatomen ist.

7. Positiv arbeitendes strahlungsempfindliches Gemisch gemäß Anspruch 1, dadurch gekennzeichnet, daß
R², R³, R⁴ und R⁶ ein Wasserstoffatom,
R⁵ eine Methylgruppe,
R⁷ einen Methyl-, Ethyl-, Trifluormethyl-, 1,1,2,3,3,3-Hexafluorpropyl-, Phenyl-, Tolyl-, 4-Fluorphenyl-, 4-Chlorphenyl-, 4-Bromphenyl oder 4-Nitrophenylrest,
m die Zahl 1 und
n die Zahl 0 oder 1
bedeuten.

8. Positiv arbeitendes strahlungsempfindliches Gemisch, gemäß einem oder mehreren der Ansprüche 1 bis 7, dadurch gekennzeichnet, daß der Anteil der säurebildenden Verbindung a) 0,5 bis 25 Gew.-%, bevorzugt 1,0 bis 15 Gew.-%, jeweils bezogen auf das Gesamtgewicht der Feststoffe des strahlungsempfindlichen Gemisches, beträgt.

9. Positiv arbeitendes strahlungsempfindliches Gemisch gemäß einem oder mehreren der Ansprüche 1 bis 8, dadurch gekennzeichnet, daß die Extinktion des Bindemittels bzw. der Kombination von Bindemitteln für Strahlung der Wellenlänge von etwa 220 bis 500 nm weniger als 0,5, bevorzugt weniger als 0,3 µm⁻¹ beträgt.

10. Positiv arbeitendes strahlungsempfindliches Gemisch gemäß einem oder mehreren der Ansprüche 1 bis 9, dadurch gekennzeichnet, daß das Bindemittel c) phenolische Hydroxygruppen enthält.

11. Positiv arbeitendes strahlungsempfindliches Gemisch gemäß Anspruch 10, dadurch gekennzeichnet, daß das Bindemittel c) bis zu 30 Gew.-%, insbesondere bis zu 20 Gew.-%, eines Novolak-Kondensationsharzes enthält.

12. Positiv arbeitendes strahlungsempfindliches Gemisch gemäß einem oder mehreren der Ansprüche 9 bis 11, dadurch gekennzeichnet, daß der Anteil des Bindemittels c) 30 bis 95 Gew.-%, bevorzugt 40 bis 90 Gew.-%, besonders bevorzugt 50 bis 85-Gew.-%, jeweils bezogen auf das Gesamtgewicht der Feststoffe des strahlungsempfindlichen Gemisches, beträgt.

13. Positiv arbeitendes strahlungsempfindliches Gemisch gemäß einem oder mehreren der Ansprüche 1 bis 12, dadurch gekennzeichnet, daß die säurelabile Verbindung b) ein monomeres oder oligomeres Acetal, ein Orthoesterderivat oder ein N-O-Acetal darstellt.

14. Positiv arbeitendes strahlungsempfindliches Gemisch gemäß Anspruch 1, dadurch gekennzeichnet, daß die 1-Sulfonyloxy-2-pyridone eine höhere molare Absorption für Strahlung der Wellenlänge von etwa 220 bis 500 nm aufweisen als die übrigen Bestandteile des Gemisches.

15. Positiv arbeitendes strahlungsempfindliches Aufzeichungsmaterial aus einem Träger und einer strahlungsempfindlichen Schicht, dadurch gekennzeichnet, daß die Schicht aus einem strahlungsempfindlichen Gemisch gemäß den Ansprüchen 1 bis 14 besteht.

16. Verfahren zur Herstellung eines Bildmusters, dadurch gekennzeichnet, daß das Aufzeichnungsmaterial gemäß Anspruch 15 bildmäßig bestrahlt, erwärmt und anschließend entwickelt wird, wobei die belichteten Bereiche des Materials gelöst bzw. entfernt werden.

17. Verfahren gemäß Anspruch 16, dadurch gekennzeichnet, daß das Aufzeichnungsmaterial mit Strahlung einer Wellenlänge von 150 bis 550 nm, bevorzugt 200 bis 450 nm, besonders bevorzugt 240 bis 440 nm, verwendet wird.

18. Verfahren gemäß Anspruch 16 oder 17, dadurch gekennzeichnet, daß die entwickelte Schicht nachgehärtet wird.

## Claims

1. A positive-working radiation-sensitive mixture with
a) a compound which generates a strong acid under the action of actinic radiation,
b) a compound having at least one C-O-C or C-O-Si bond cleavable by acid and
c) a polymeric binder which is insoluble in water and soluble or at least swellable in aqueous alkaline solutions,
wherein the compound a) is a 1-sulfonyloxy-2-pyridone of the formula I 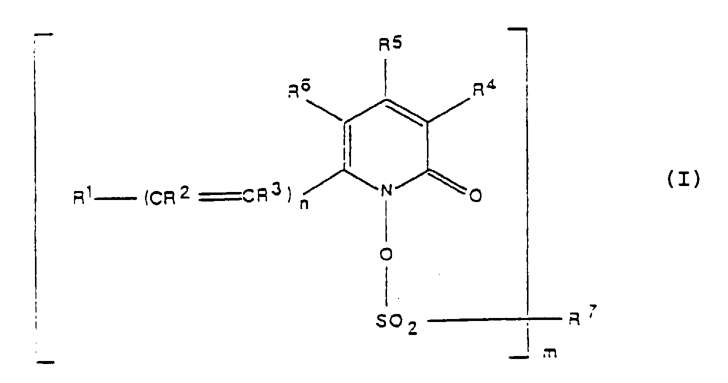 in which
R¹ is a hydrogen atom or an alkyl, cycloalkyl, aryl, aralkenyl, heteroaryl or heteroaralkenyl radical,
R² is hydrogen, chlorine, bromine or an alkyl, cycloalkyl, aryl or heteroaryl radical, or
R¹ and R² together form a five- to eight-membered ring,
R³ is hydrogen or an alkyl radical,
R⁴ is hydrogen, halogen, nitro, acylamino, cyano, thiocyanato or an alkyl, alkenyl, alkynyl, aryl, aralkyl, alkylthio, arylthio or cycloalkylthio radical,
R⁵ is hydrogen or an alkyl or aryl radical or
R⁴ and R⁵ together form a five- to eight-membered ring,
R⁶ is hydrogen, halogen, nitro, acylamino, cyano, thiocyanato or an alkyl, alkenyl, alkoxyalkyl, aryl, aralkyl, alkylthio, cycloalkylthio or arylthio radical,
R⁷ is an alkyl or cycloalkyl radical, a perfluorinated or highly fluorinated alkyl radical or an aryl, arylalkyl or heteroaryl radical or an alkylene or arylene radical,
m is the number 1 or 2 and
n is an integer from 0 to 3.

2. A positive-working radiation-sensitive mixture as claimed in claim 1, wherein
R¹ is an alkyl or cycloalkyl radical or an aryl radical of the formula II 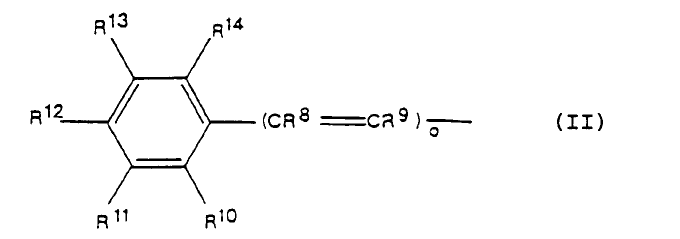 in which
R⁸ and R⁹ are identical or different and are hydrogen or a lower alkyl or aryl group,
R¹⁰ to R¹⁴ are identical or different and are hydrogen, an alkyl, alkenyl, alkoxy, alkylthio or alkanesulfonyl radical each having up to 6 carbon atoms, a cycloalkyloxy, cycloalkylthio or cycloalkanesulfonyl radical having up to 8 carbon atoms, a phenyl, styryl, phenoxy, phenylthio, benzenesulfonyl, phenylalkoxy, phenylalkylthio or phenylalkanesulfonyl radical which may be substituted on the aromatic ring and has up to 3 carbon atoms in the alkyl chain, hydroxyl, halogen, trifluoromethyl, nitro, cyano, alkoxycarbonyl, carbamoyl which may be substituted on the nitrogen by one or two alkyl radical(s) which may be linked to form a 5- to 7-membered ring, sulfamoyl which may be substituted on the nitrogen by one or two alkyl radical(s) which may be linked to form a 5- to 7-membered ring, alkanesulfonyloxy, arylsulfonyloxy, acylamino, alkylamino or arylamino,
or two mutually adjacent substituents R¹⁰ to R¹⁴ form one or two further fused ring(s), and
o is the number 0 or 1.

3. A positive-working radiation-sensitive mixture as claimed in claim 1 or 2, wherein R¹ is a 5- or 6-membered heterocyclic ring having up to three heteroatoms, of the formula III

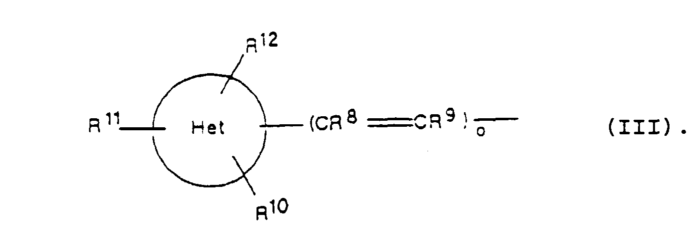

4. A positive-working radiation-sensitive mixture as claimed in any of claims 1 to 3, wherein, in the formula I,
R¹ is a ferrocenyl radical and
R² is hydrogen, chlorine, bromine, alkyl, cycloalkyl or a radical of the formula II or III or
R¹ and R² together form a five- to eight-membered ring,
R³ is hydrogen or an alkyl radical,
R⁴ is hydrogen, halogen, nitro, acylamino, cyano, thiocyanato or an alkyl, aryl, alkylthio, arylthio or cycloalkylthio radical,
R⁵ is hydrogen or an alkyl or aryl radical or
R⁴ and R⁵ together form a five- to eight-membered ring,
R⁶ is hydrogen, halogen, nitro, acylamino, cyano, thiocyanato or an alkyl, aryl, alkylthio, arylthio or cycloalkylthio radical,
R⁷ is an alkyl or cycloalkyl radical, a perfluorinated or highly fluorinated alkyl radical or an aryl, arylalkyl or heteroaryl radical or an alkylene or arylene radical and
n is an integer from 0 to 3 and
m is the number 1 or 2.

5. A positive-working radiation-sensitive mixture as claimed in claim 1, wherein R⁷ is an alkyl radical having 1 to 4 carbon atoms, a highly fluorinated or perfluorinated alkyl radical having 1 to 4 carbon atoms or an aryl radical of the formula IV 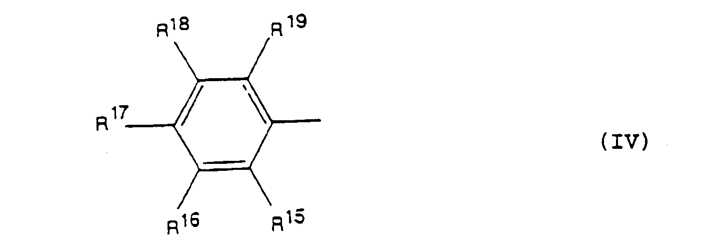 in which R¹⁵ to R¹⁹ are identical or different and are hydrogen atoms or halogen atoms, preferably fluorine, chlorine or bromine, alkyl radicals which have up to 6 carbon atoms and are unsubstituted or substituted by halogen atoms, preferably chlorine or bromine, aryl or aryloxy radicals and in which individual methylene groups can be replaced by oxygen or sulfur atoms and in which in each case two of these radicals can be linked to form a 5- or 6-membered ring, cycloalkyl radicals having up to 8 carbon atoms, alkenyl radicals having up to 6 carbon atoms or aryl or aryloxy radicals having up to 10 carbon atoms, the total number of the carbon atoms in the radicals R¹⁵ to R¹⁹ being not more than 12.

6. A positive-working radiation-sensitive mixture as claimed in claim 1, wherein R⁷ is a naphthyl or heteroaryl radical having up to 10 carbon atoms, an alkylene radical having up to 6 carbon atoms or an arylene or heteroarylene radical having up to 14 carbon atoms.

7. A positive-working radiation-sensitive mixture as claimed in claim 1, wherein
R², R³, R⁴ and R⁶ are a hydrogen atom,
R⁵ is a methyl group,
R⁷ is a methyl, ethyl, trifluoromethyl, 1,1,2,3,3,3-hexafluoropropyl, phenyl, tolyl, 4-fluorophenyl, 4-chlorophenyl, 4-bromophenyl or 4-nitrophenyl radical,
m is the number 1 and
n is the number 0 or 1.

8. A positive-working radiation-sensitive mixture as claimed in one or more of claims 1 to 7, wherein the content of the acid-generating compound a) is 0.5 to 25% by weight, preferably 1.0 to 15% by weight, each relative to the total weight of the solids in the radiation-sensitive mixture.

9. A positive-working radiation-sensitive mixture as claimed in one or more of claims 1 to 8, wherein the extinction of the binder or of the combination of binders for radiation of wavelength from about 220 to 500 nm is less than 0.5, preferably less than 0.3 µm⁻¹.

10. A positive-working radiation-sensitive mixture as claimed in one or more of claims 1 to 9, wherein the binder c) contains phenolic hydroxyl groups.

11. A positive-working radiation-sensitive mixture as claimed in claim 10, wherein the binder c) contains up to 30% by weight, especially up to 20% by weight, of a novolak condensation resin.

12. A positive-working radiation-sensitive mixture as claimed in one or more of claims 9 to 11, wherein the content of the binder c) is 30 to 95% by weight, preferably 40 to 90% by weight, particularly preferably 50 to 85% by weight, each relative to the total weight of the solids in the radiation-sensitive mixture.

13. A positive-working radiation-sensitive mixture as claimed in one or more of claims 1 to 12, wherein the acid-unstable compound b) is a monomeric or oligomeric acetal, an ortho-ester derivative or an N-O-acetal.

14. A positive-working radiation-sensitive mixture as claimed in claim 1, wherein the 1-sulfonyloxy-2-pyridone has a higher molar absorption for radiation of wavelength from about 220 to 500 nm than the remaining constituents of the mixture.

15. A positive-working radiation-sensitive recording material composed of a support and a radiation-sensitive layer, wherein the layer comprises a radiation-sensitive mixture as claimed in any of claims 1 to 14.

16. A method for preparing an image pattern, which comprises irradiating the recording material as claimed in claim 15 imagewise, heating and then developing it, the exposed areas of the material being dissolved or removed.

17. The method as claimed in claim 16, wherein the recording material is used with radiation of a wavelength from 150 to 550 nm, preferably 200 to 450 nm, particularly preferably 240 to 440 nm.

18. The method as claimed in claim 16 or 17, wherein the developed layer is post-hardened.

## Revendications

1. Mélange positif sensible au rayonnement avec
a) un composé qui forme un acide fort sous l'effet de rayonnement actinique,
b) un composé avec au moins une liaison C-O-C ou C-O-Si, dissociable par un acide et
c) un liant insoluble dans l'eau, mais soluble ou au moins gonflable dans des solutions aqueuses alcalines,
caractérisé en ce que le composé (a) est une 1-sulfonyloxy-2-pyridone de formule générale I 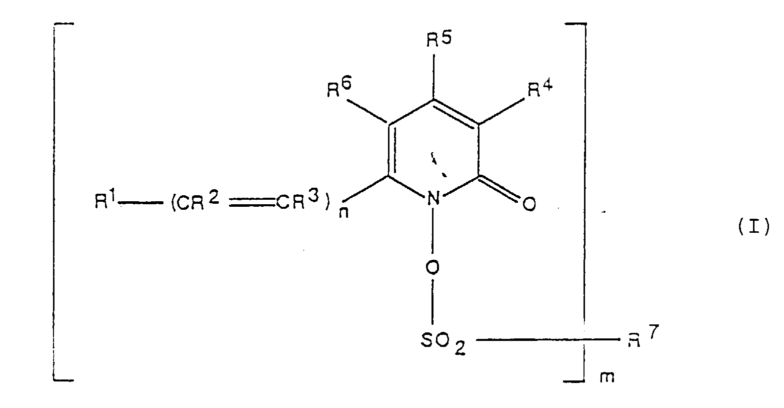 dans laquelle
R¹ représente un atome d'hydrogène, un reste alkyle, cycloalkyle, aryle, aralcényle, hétéroaryle ou hétéroaralcényle,
R² représente des atomes d'hydrogène, de chlore, de brome, un reste alkyle, cycloalkyle, aryle ou hétéroaryle, ou
R¹ et R² ensemble, forment un cycle de 5 à 8 chaînons,
R³ représente un atome d'hydrogène ou un reste alkyle,
R⁴ représente un atome d'hydrogène, un atome d'halogène, des groupes nitro, acylamino, cyan, thiocyanato, un reste alkyle, alcényle, alcynyle, aryle, aralkyle, alkylthio, arylthio ou cycloalkylthio,
R⁵ représente un atome d'hydrogène, un reste alkyle ou aryle, ou
R⁴ et R⁵ ensemble forment un cycle de 5 à 8 chaînons,
R⁶ représente un atome d'hydrogène, un atome d'halogène, des groupes nitro, acylamino, cyan, thiocyanato, un reste alkyle, alcényle, alkoxyalkyle, aryle, aralkyle, alkylthio, cycloalkylthio ou arylthio,
R⁷ représente un reste alkyle, cycloalkyle, alkyle per- ou hautement fluoré ou un reste aryle, arylalkyle ou hétéroaryle ou un reste alkylène ou arylène,
m vaut 1 ou 2 et
n est un nombre entier de 0 à 3.

2. Mélange poositif sensible au rayonnement selon la revendication 1, caractérisé en ce que
R¹ représente un reste alkyle ou cycloalkyle ou un reste aryle de formule générale II 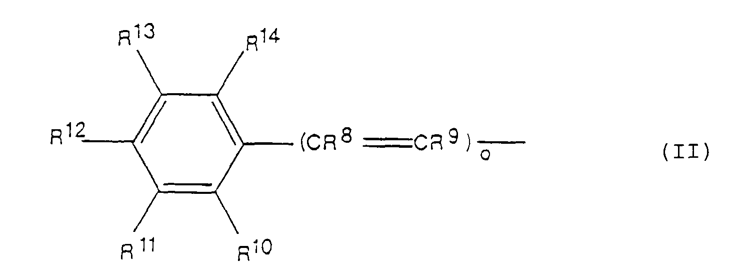 dans laquelle
R⁸ et R⁹ sont identiques ou différents et représentent un atome d'hydrogène, un groupe alkyle ou aryle inférieur,
R¹⁰ à R¹⁴ sont identiques ou différents et représentent un reste alkyle, alcényle, alkyloxy, alkylthio, alcanesulfonyle chacun avec jusqu'à 6 atomes de carbone, un reste, éventuellement substitué sur le cycle aromatique, cycloalkoxy, cycloalkylthio, cycloalcane-sulfonyle avec jusqu'à 8 atomes de carbone, éventuellement un reste phényle, styryle, phénoxy, phénylthio, benzènesulfonyle, phénylalkoxy, phénylalkylthio, phénylalcanesulfonyle avec jusqu'à 3 atomes de carbone dans la chaîne alkyle, des groupes hydroxy, halogène, trifluorométhyle, nitro, cyan, alkoxycarbonyle, carbamoyle, lequel est éventuellement substitué sur l'atome d'azote par un ou deux reste(s) alkyle, qui sont éventuellement reliés en un cycle de 5 à 7 chaînons, sulfamoyle, lequel est éventuellement substitué sur l'atome d'azote par un ou deux reste(s) alkyle, qui sont éventuellement reliés en un cycle de 5 à 7 chaînons, alcanesulfonyloxy, arylsulfonyloxy, acylamino, alkylamino ou arylamino,
ou deux des substituants R¹⁰ à R¹⁴ adjacents forment un ou deux autre(s) cycle(s) condensés, et
o vaut 0 ou 1.

3. Mélange positif sensible au rayonnement selon les revendications 1 ou 2, caractérisé en ce que R¹ représente un hétérocycle de 5 à 6 chaînons avec jusqu'à hétéroatomes de formule générale III

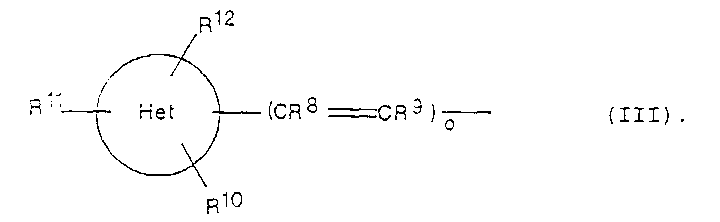

4. Mélange positif sensible au rayonnement selon les revendications 1 à 3, caractérisé en ce que dans la formule générale I
R² représente des atomes d'hydrogène, de chlore, de brome, des restes alkyle, cycloalkyle ou un reste de formules générales II ou III ou
R¹ et R² ensemble forment un cycle de 5 à 8 chaînons,
R³ représente un atome d'hydrogène ou un reste alkyle,
R⁴ représente un atome d'hydrogène, un atome d'halogène, des groupes nitro, acylamino, cyan, thiocyanato, un reste alkyle, aryle, alkylthio, arylthio ou cycloakylthio,
R⁵ représente un atome d'hydrogène, un reste alkyle ou aryle ou
R⁴ et R⁵ ensemble forment un cycle de 5 à 8 chaînons,
R⁶ représente un atome d'hydrogène, un atome d'halogène, des groupes nitro, acylamino, cyan, thiocyanato, un reste alkyle, aryle, alkylthio, arylthio ou cycloalkylthio,
R⁷ représente un reste alkyle, cycloalkyle, alkyle per- ou hautement fluoré, ou un reste aryle, arylalkyle, aryle ou hétéroaryle ou un reste alkylène ou arylène et
n est un nombre entier de 0 à 3 et
m vaut 1 ou 2.

5. Mélange positif sensible au rayonnement selon la revendication 1, caractérisé en ce que R⁷ représente un reste alkyle avec 1 à 4 atomes de carbone, un reste alkyle per- ou hautement fluoré avec 1 à 4 atomes de carbone ou un reste aryle de formule générale IV 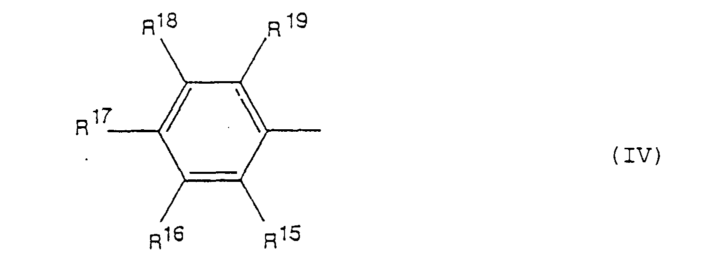 dans laquelle R¹⁵ à R¹⁹ sont identiques ou différents et représentent des atomes d'hydrogène ou d'halogène, qui sont de préférence le fluor, le chlore ou le brome, des restes alkyle avec jusqu'à 6 atome de carbone, qui sont non substitués ou substitués par des atomes d'halogène, de préférence le chlore ou le brome, des restes aryle ou aryloxy, et dans lesquels les différents groupes méthylène peuvent être remplacés par des atomes d'oxygène ou de soufre et chacun de ces restes pouvant être relié en formant un cycle de 5 ou 6 chaînons, des restes cycloalkyle avec jusqu'à 8 atomes de carbone, des restes alcényle avec jusqu'à 6 atomes de carbone, des restes aryle ou aryloxy avec jusqu'à 10 atomes de carbone et le nombre total des atomes de carbone des restes R¹⁵ à R¹⁹ étant de 12 au maximum.

6. Mélange positif sensible au rayonnement selon la revendication 1, caractérisé en ce que R⁷ représente un reste naphtyle ou hétéroaryle avec jusqu'à 10 atomes de carbone, un reste alkylène avec jusqu'à 6 atomes de carbone ou un reste arylène ou hétéroarylène avec jusqu'à 14 atomes de carbone.

7. Mélange positif sensible au rayonnement selon la revendication 1, caractérisé en ce que
R², R³, R⁴ et R⁵ représentent un atome d'hydrogène,
R⁵ un groupe méthyle,
R⁷ un reste méthyle, éthyle, trifluorméthyle, 1,1,2,3,3,3-hexafluoropropyle, phényle, tolyle, 4-fluorophényle, 4-chlorophényle, 4-bromophényle ou 4-nitrophényle,
m vaut 1 et
n vaut 0 ou 1.

8. Mélange positif sensible au rayonnement selon une ou plusieurs des revendications 1 à 7, caractérisé en ce que le taux en composé formateur d'acide a) est de 0,5 à 25 % en poids, de préférence de 1,0 à 15 % en poids, à chaque fois par rapport au poids total de l'extrait sec dans le mélange sensible au rayonnement.

9. Mélange positif sensible au rayonnement selon une ou plusieurs des revendications 1 à 8, caractérisé en ce que l'extinction du liant ou de la combinaison de liants pour le rayonnement d'une longueur d'onde d'environ 220 à 500 nm est inférieure à 0,5, de préférence inférieure à 0,3 µm⁻¹.

10. Mélange positif sensible au rayonnement selon une ou plusieurs des revendications 1 à 9, caractérisé en ce que le liant contient des groupes hydroxyle phénoliques.

11. Mélange positif sensible au rayonnement selon la revendication 10, caractérisé en ce que le liant c) contient jusqu'à 30 % en poids, en particulier jusqu'à 20 % en poids d'une résine de condensation de novolaque.

12. Mélange positif sensible au rayonnement selon une ou plusieurs des revendications 9 à 11, caractérisé en ce que le taux en liant c) est de 30 à 95 % en poids, de préférence de 40 à 90 % en poids, de manière particulièrement préférée de 50 à 85 % en poids, à chaque fois par rapport au poids total de l'extrait sec du mélange sensible au rayonnement.

13. Mélange positif sensible au rayonnement selon une ou plusieurs des revendications 1 à 12, caractérisé en ce que le composé formateur d'acide b) est un dérivé ortho-ester, un N-O-acétal ou un acétal monomère ou oligomère.

14. Mélange positif sensible au rayonnement selon la revendication 1, caractérisé en ce que les 1-sulfonyloxy-2-pyridones présentent une absorption molaire plus élevée pour le rayonnement d'une longueur d'onde d'environ 220 à 500 nm que les autres composants du mélange.

15. Mélange positif sensible au rayonnement constitué d'un support et d'une couche sensible au rayonnement, caractérisé en ce que la couche est constituée d'un mélange sensible au rayonnement selon les revendications 1 à 14.

16. Procédé pour la préparation d'un modèle d'image, caractérisé en ce que l'on irradie la matière d'enregistrement selon la revendication 15 selon le modèle, on chauffe et ensuite on développe, les régions irradiées de la matière étant dissoutes ou bien éliminées.

17. Procédé selon la revendication 16, caractérisé en ce que l'on utilise la matière d'enregistrement avec un rayonnement d'une longueur d'onde de 150 à 550 nm, de préférence de 200 à 450 nm, de manière particulièrement préférée de 240 à 440 nm.

18. Procédé selon la revendication 16 ou 17, caractérisé en ce que la couche développée est soumise à un post-durcissement.
